# EUROPEAN PATENT SPECIFICATION

(11) **EP 4 340 166 B1**
(45) Date of publication and mention of the grant of the patent: **15.10.2025**
(21) Application number: 22849717.8
(22) Date of filing: 16.06.2022
(51) Int. Cl.: H02J 7/00, H02J 7/34, G06F 1/26, G01R 31/3835, G06F 3/04815, G06F 3/01, G06F 3/00, G02B 27/01

(54) **ELECTRONIC APPARATUS FOR CHARGING ANOTHER ELECTRONIC APPARATUS, AND METHOD FOR CONTROLLING ELECTRONIC APPARATUS FOR CHARGING OTHER ELECTRONIC APPARATUS**
ELEKTRONISCHE VORRICHTUNG ZUM LADEN EINER ANDEREN ELEKTRONISCHEN VORRICHTUNG UND VERFAHREN ZUR STEUERUNG DER ELEKTRONISCHEN VORRICHTUNG ZUM LADEN EINER ANDEREN ELEKTRONISCHEN VORRICHTUNG
APPAREIL ÉLECTRONIQUE POUR CHARGER UN AUTRE APPAREIL ÉLECTRONIQUE, ET PROCÉDÉ DE COMMANDE D'APPAREIL ÉLECTRONIQUE POUR CHARGER UN AUTRE APPAREIL ÉLECTRONIQUE

(30) Priority: 27.07.2021 KR 20210098789
(43) Date of publication of application: 20.03.2024
(73) Proprietor: Samsung Electronics Co., Ltd., Suwon-si, Gyeonggi-do 16677 (KR)
(72) Inventor: YOON, Jongmin, Suwon-si Gyeonggi-do 16677 (KR); YOON, Youngho, Suwon-si Gyeonggi-do 16677 (KR)
(74) Representative: HGF
(86) International application number: PCT/KR2022/008520
(87) International publication number: WO 2023/008738

(56) References cited:
- KR-A- 20160 143 077
- KR-A- 20210 034 431
- KR-A- 20210 043 351
- US-A1- 2009 115 374
- US-A1- 2015 378 411
- US-A1- 2016 359 322
- US-A1- 2018 248 397
- US-A1- 2021 111 577

## Description

### [Technical Field]

The disclosure relates to an electronic device for charging another electronic device and a method of controlling an electronic device for charging another electronic device.

### [Background Art]

Augmented reality (AR) is technology that superimposes a three-dimensional (or a two-dimensional) virtual image on the image of reality or a background so as to show a single image. The AR technology in which a real environment and a virtual object are mixed may show the real environment to a user, and may provide additional information with an improved sense of reality.

An AR device may be connected to a case that is capable of accommodating the AR device, and capable of charging the battery of the AR device. The case may be connected to an external power source while being connected to the AR device and charging the battery of the AR device. In this instance, the external power source may be used for charging the battery of the case and the battery of the AR device.

US2018/248397A1 concerns techniques for transferring power from a portable power bank to an electronic device. More particularly, a disclosed power bank incorporates a switching mechanism capable of routing battery voltage or a stepped-up voltage (e.g., from a boost regulator) directly to a common portion of an output connector. In addition, electronic devices incorporating a switching mechanism to allow them to accept direct battery output or a stepped-up voltage at a common portion of the device's connector (e.g., a USB connector).

US2021/111577A1 concerns an electronic device. The electronic device includes a battery, an interface configured to support a connection with an external power supply unit, a charging circuit configured to charge the battery with a power being supplied from the external power supply unit, and a processor configured to receive information on the supplied power of the external power supply unit from the external power supply unit, determine a voltage to be supplied from the external power supply unit based on supplied voltage information of the external power supply unit and status information of the battery, transmit information on the determined voltage to the external power supply unit, and charge the battery with the determined voltage. The determined voltage is a voltage determined so that a difference between an input voltage and an output voltage of the charging circuit is minimized.

US2016/359322A1 concerns an electronic device including a connector for connecting to an external device; a battery; and a controller operatively coupled to the connector and the battery. The controller includes a power controller configured to: supply the external device with a first signal having a first voltage level in response to detecting that the external device is connected to the connector. The external device is supplied with a second signal having a second voltage level that differs from the first voltage level, in response to detecting that the external device is connected to an external power supply. The first signal is generated at least in part by the battery.

### [Detailed Description of the Disclosure]

### [Technical Problem]

If an external power source is connected to the case of an augmented reality (AR) device and charges the battery of the case, and the case is connected to the AR device and charges the battery of the AR device, or if the external power source is not connected to the case of the AR device and the battery of the AR device is charged using the battery power of the case, a power loss may occur in various steps of the charging process. Accordingly, there is a desire for increasing the efficiency of charging.

According to an embodiment, a first electronic device that charges a second electronic device may adjust a voltage output to the second electronic device.

### [Technical Solution]

A first electronic device is provided according to claim 1.

A method performed in a first electronic device configured to supply power to a second electronic device is provided according to claim 14.

### [Advantageous Effects]

According to an embodiment, there are provided an electronic device for charging another electronic device and a method of controlling an electronic device for charging another electronic device. According to an embodiment, a method performed in a first electronic device configured to supply power to a second electronic device may adjust the voltage of power input to the second electronic device based on the voltage of a first battery of the first electronic device, the voltage of a second battery of the second electronic device, and the minimum voltage required for operating a charger of the second electronic device, and may reduce a loss of power.

### [Brief Description of Drawings]

FIG. 1 is a diagram illustrating the structure of a second electronic device that is charged by a first electronic device according to various embodiments;
FIG. 2 is a block diagram of a second electronic device that is charged by a first electronic device according to various embodiments;
FIG. 3 is a diagram illustrating the structure of a display and an eye tracking camera of a second electronic device that is charged by a first electronic device, according to various embodiments;
FIG. 4 is a block diagram of a first electronic device according to various embodiments;
FIG. 5 is a diagram illustrating a connection among a first electronic device, a second electronic device charged by the first electronic device, and a host device according to various embodiments;
FIG. 6 is a block diagram of a first electronic device according to various embodiments;
FIG. 7 is a block diagram of a second electronic device that is charged by a first electronic device according to various embodiments;
FIG. 8 is a flowchart illustrating operations performed by a first electronic device according to various embodiments;

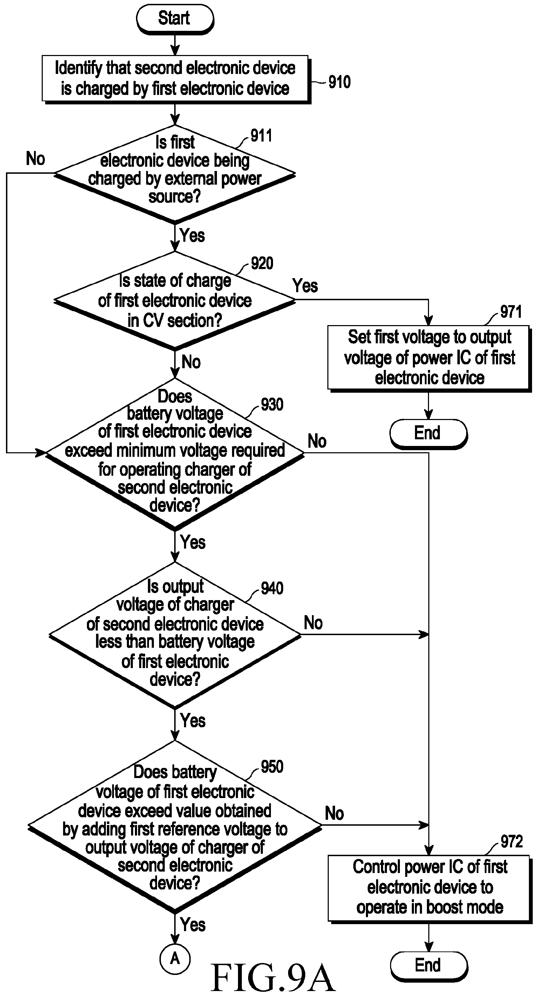

FIG. 9A is a flowchart illustrating operations performed by a first electronic device according to various embodiments;

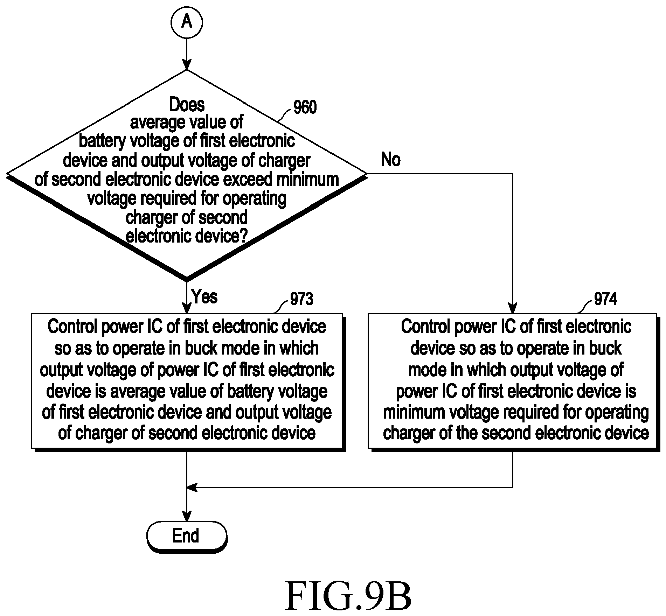

FIG. 9B is a flowchart illustrating operations performed by a first electronic device according to various embodiments;
FIG. 10A is a diagram illustrating a voltage when a first electronic device according to various embodiments operates in a buck mode and a voltage in a comparative example;
FIG. 10B is a diagram illustrating a voltage when a first electronic device according to various embodiments operates in a boost mode and a voltage in a comparative example;
FIG. 11A is a diagram illustrating an example of charging efficiency according to a comparative example;
FIG. 11B is a diagram illustrating an example of charging efficiency according to various embodiments;
FIG. 12A is a diagram illustrating an example of a charging curve according to a comparative example;
FIG. 12B is a diagram illustrating an example of a charging curve according to various embodiments;
FIG. 13A is a diagram illustrating an example of charging curves according to a comparative example and various embodiments, in the state in which a first electronic device does not receive power supplied from another electronic device and charges a second electronic device;
FIG. 13B is a diagram illustrating an example of charging curves according to a comparative example and various embodiments, in the state in which a first electronic device receives power supplied from another electronic device and charges a second electronic device; and
FIG. 14 is a block diagram illustrating an electronic device in a network environment according to various embodiments.

### [Mode for Carrying out the Disclosure]

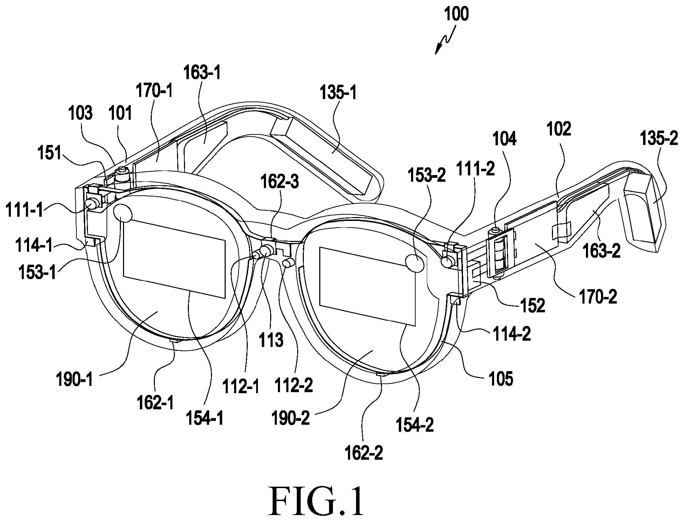

FIG. 1 is a diagram illustrating the structure of a second electronic device that is charged by a first electronic device according to various embodiments. According to various embodiments, a second electronic device 100 may include one or more first cameras 111-1 and 111-2, one or more second cameras 112-1 and 112-2, and one or more third cameras 113.According to various embodiments, an image obtained via the one or more first cameras 111-1 and 111-2 may be used for detecting a hand gesture made by a user, tracking the head of the user, and/or awareness of space. According to various embodiments, the one or more first cameras 111-1 and 111-2 may be global shutter (GS) camera or rolling shutter (RS) cameras. According to various embodiments, the one or more first cameras 111-1 and 111-2 may perform a simultaneous localization and mapping (SLAM) operation via depth shooting. According to various embodiments, the one or more first cameras 111-1 and 111-2 may perform space awareness for 3 degrees of freedom (DoF) and/or 6DoF.

According to various embodiments, an image obtained via the one or more second cameras 112-1 and 112-2 may be used for detecting and tracking the pupils of a user.According to various embodiments, one or more second cameras 112-1 and 112-2 may be GS cameras. According to various embodiments, the one or more second cameras 112-1 and 112-2 may correspond to the left eye and the right eye, respectively, and the performance of the one or more second cameras 112-1 and 112-2 may be the same.

According to various embodiments, one or more third cameras 113 may be high-resolution cameras. According to various embodiments, the one or more third cameras 113 may perform an auto-focusing (AF) function and an image stabilization function (OIS).According to various embodiments, one or more third cameras 113 may be GS cameras or rolling shutter (RS) cameras. According to various embodiments, one or more third cameras 113 may be color cameras.

According to various embodiments, the second electronic device 100 may include one or more light emitting devices 114-1 and 114-2.The light emitting devices 114-1 and 114-2 may be different from a light source that emits light to a screen output area of a display, which will be described later. According to various embodiments, the light emitting devices 114-1 and 114-2 may emit light so as to easily detect the pupils of a user when detecting and tracking the pupils of the user via the one or more second cameras 112-1 and 112-2.According to various embodiments, each of the light emitting devices 114-1 and 114-2 may include an LED. According to various embodiments, the light emitting devices 114-1 and 114-2 may emit an infrared light. According to various embodiments, the light emitting devices 114-1 and 114-2 may be attached to around the frame of the second electronic device 100.According to various embodiments, if the light emitting devices 114-1 and 114-2 are located around the one or more first cameras 111-1 and 111-2, and the second electronic device 100 is used in a dark environment, the light emitting devices 114-1 and 114-2 may assist the one or more first cameras 111-1 and 111-2 to perform gesture detection, head tracking, and space awareness. According to various embodiments, if the light emitting devices 114-1 and 114-2 are located around the one or more third cameras 113, and the second electronic device 100 is used in a dark environment, the light emitting devices 114-1 and 114-2 may assist the one or more third camera 113 to obtain an image.

According to various embodiments, the second electronic device 100 may include batteries 135-1 and 135-2.The batteries 135-1 and 135-2 may store power for operating the remaining elements of the second electronic device 100.

According to various embodiments, the second electronic device 100 may include a first display 151, a second display 152, one or more input optical members 153-1 and 153-2, one or more transparent members 190-1 and 190-2, and one or more screen display parts 154-1 and 154-2.According to various embodiments, the first display 151 and the second display 152 may include, for example, a liquid crystal display (LCD), a digital mirror device (DMD), a liquid crystal on silicon (LCoS), an organic light emitting diode (OLED), or a micro light emitting diode (micro LED).According to various embodiments, if the first display 151 and the second display 512 are embodied as one of an LCD, an DMD, or an LCoS, the second electronic device 100 may include a light source that emits light to the screen output area of the display. According to various other embodiments, if the first display 151 and the second display 152 autonomously emit light, for example, if the first display 151 and the second display 152 are embodied as one of an OLED or a micro LED, the second electronic device 100 may provide a virtual image of a good quality to a user even when the second electronic device 100 does not include a separate light source.

According to various embodiments, the one or more transparent members 190-1 and 190-2 may be disposed to face the eyes of a user when the user wears the second electronic device 100.According to various embodiments, the one or more transparent members 190-1 and 190-2 may include at least one of a glass plate, a plastic plate, or a polymer. According to various embodiments, if a user wears the second electronic device 100, the user is capable of viewing the outside world via the one or more transparent members 190-1 and 190-2.According to various embodiments, the one or more input optical members 153-1 and 153-2 may guide a light produced from the first display 151 and the second display 152 to the eyes of a user.According to various embodiments, an image based on a light produced by the first display 151 and the second display 152 is formed on the one or more screen display parts 154-1 and 154-4 of the one or more transparent members 190-1 and 190-2, and a user may view the image formed on the one or more screen display parts 154-1 and 154-2.

According to various embodiments, the second electronic device 100 may include one or more optical waveguides (not illustrated). The optical waveguides may transfer a light produced by the first display 151 and the second display 152 to the eyes of a user.The second electronic device 101 may include optical waveguides that respectively correspond to the left eye and the right eye.According to various embodiments, an optical waveguide may include at least one of glass, plastic, or polymer. According to various embodiments, the optical waveguide may include a nano pattern formed in one inner or outer surface, for example, a grating structure in the form of a polygonal or curved surface shape. According to various embodiments, the optical waveguide may include a free-form type prism, and in this instance, the optical waveguide may provide an incident light to a user via a reflection mirror. According to various embodiments, the optical waveguide may include at least one diffractive element (e.g., a diffractive optical element (DOE), a holographic optical element (HOE), or reflective element (e.g., a reflective mirror), and a display light emitted from a light source may be guided to the eyes of a user using at least one diffractive element or reflective element included in the optical waveguide. According to various embodiments, the diffractive element may include an input/output optical member. According to various embodiments, the reflective element may include a member that causes total reflection.

According to various embodiments, the second electronic device 100 may include one or more voice input devices 162-1, 162-2, and 162-3, and one or more voice output devices 163-1 and 163-2.

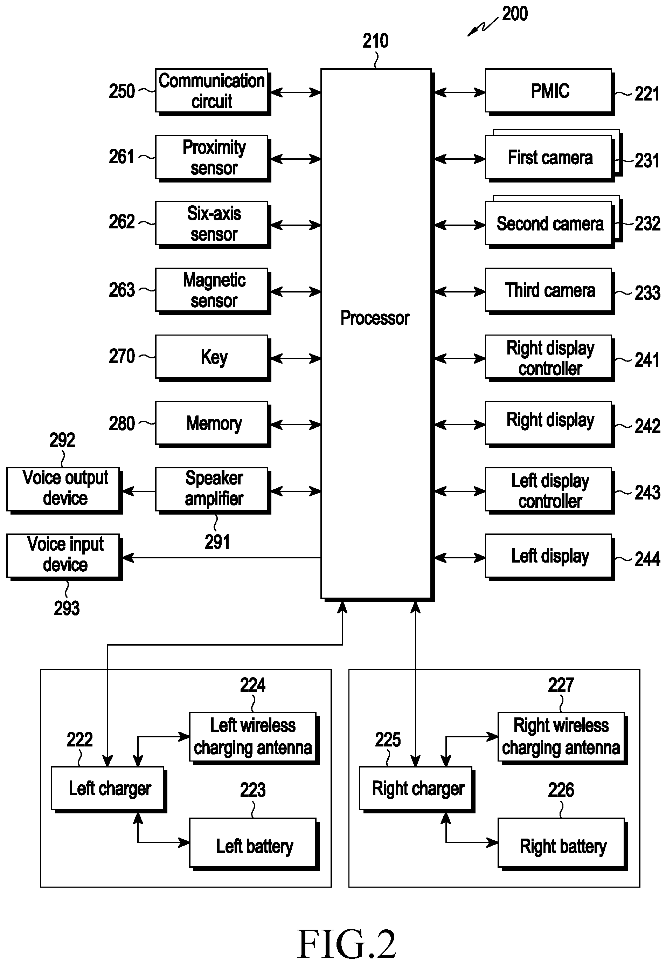

According to various embodiments, the second electronic device 100 may include a first PCB 170-1 and a second PCB 170-2.The first PCB 170-1 and the second PCB 170-2 may transfer an electric signal to elements included in the second electronic device 100, such as a first camera 111, a second camera 112, and the third camera 113, a display module 150, an audio module 161, and a sensor 180, which will be described with reference to FIG. 2. According to various embodiments, the first PCB 170-1 and the second PCB 170-2 may be FPCBs. According to various embodiments, the first PCB 170-1 and the second PCB 170-2 may include a first substrate, a second substrate, and an interposer disposed between the first substrate and the second substrate.

FIG. 2 is a block diagram of a second electronic device that is charged by a first electronic device according to various embodiments. A second electronic device 200 may include a processor 210, a first camera 231, a second camera 232, a third camera 233, a PMIC 221, a left charger 222, a left wireless charging antenna 224, a left battery 223, a right charger 225, a right wireless charging antenna 227, a right battery 226, a right display controller 241, a right display 242, a left display controller 243, a left display 244, a communication circuit 250, an proximity sensor 261, a six-axis sensor 262, a magnetic sensor 263, a key 270, a memory 280, a speaker amplifier 291, a voice output device 292, and a voice input device 293.

According to various embodiments, the processor 210 may control other elements of the second electronic device 200, for example, the first camera 231, the second camera 232, the third camera 233, the PMIC 221, the right display controller 241, the left display controller 243, the communication circuit 250, the memory 280, and the speaker amplifier 291, and may perform various data processing and operations.

According to various embodiments, details of the one or more first cameras 111-1 and 111-2, the one or more second cameras 112-1 and 112-2, and one or more third cameras 113 which will be described with reference to FIG. 1 may be equally applied to the first camera 231, the second camera 232, and the third camera 233.According to various embodiments, the second electronic device 200 may include a plurality of cameras of a type of at least one of the first camera 231, the second camera 232, and the third camera 233.

According to various embodiments, the PMIC 221 may convert power stored in the left battery 223 and the right battery 226 to have a current or voltage that other elements of the second electronic device 200 require, and may supply the power to the other elements of the second electronic device 200.According to various embodiments, the right battery 226 may be implemented as the battery 135-1 of FIG. 1, and the left battery 223 may be implemented as the battery 135-2 of FIG. 1. According to various embodiments, the left charger 222 may charge the left battery 223 based on wireless power received via the left wireless charging antenna 224.According to various embodiments, the right charger 225 may charge the right battery 226 based on wireless power received via the right wireless charging antenna 227.

According to various embodiments, the right display controller 241 and the right display 242 may be included in the first display 151 as described with reference to FIG. 1. According to various embodiments, the right display controller 241 may control a driving unit of the right display 242.According to various embodiments, the right display 242 may transfer a light source and may display a screen. According to various embodiments, the left display controller 243 and the left display 244 may be included in the second display 152 as described with reference to FIG. 1. According to various embodiments, the left display controller 243 may control a driving unit of the left display 244.According to various embodiments, the left display 244 may transfer a light source and may display a screen.

According to various embodiments, the communication circuit 250 may establish a wireless communication channel to an external electronic device of the second electronic device 200, and may support communication via the established communication channel.

According to various embodiments, the second electronic device 200 may further include other types of sensors in addition to the proximity sensor 261, the six-axis sensor 262, the magnetic sensor 263.

According to various embodiments, the memory 280 may store various data used by at least one element (e.g., the processor 210) of the second electronic device 200.

According to various embodiments, the speaker amplifier 291 may be connected to the voice output device 292, and may produce data to be transferred to the voice output device 292.According to various embodiments, the voice output device 292 may include a speaker.

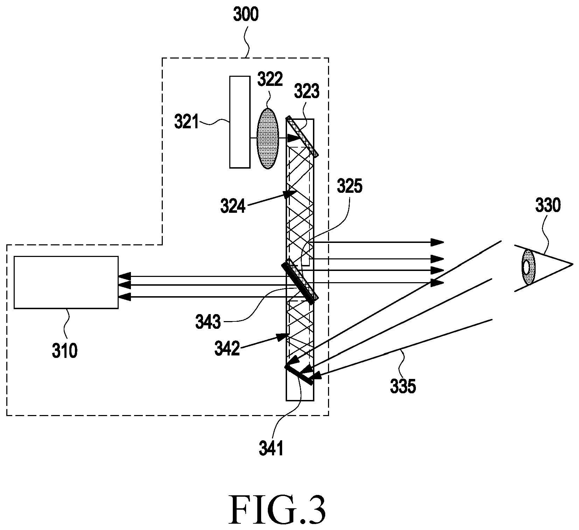

FIG. 3 is a diagram illustrating the structure of a display and an eye tracking camera of a second electronic device that is charged by a first electronic device according to various embodiments. A second electronic device 300 (e.g., the second electronic device 100 of FIG. 1) may include a display 321, a projection lens 322, an input optical member 323, a display optical waveguide 324, an output optical member 325, an eye tracking camera 310, a first splitter 341, an eye tracking waveguide 342, and/or a second splitter 343.

The display 321 in the second electronic device 300 may be the first display 151 or the second display 152 of FIG. 1. A light output from the display 321 may be refracted by the projection lens 322, and may converge on a smaller caliber area. A light refracted by the projection lens 322 may meet the input optical member 323 (e.g., the input optical member 153-1 and 153-2 of FIG. 1), may be incident to the display optical waveguide 324, may pass through the display optical waveguide 324, and may be output via the output optical member 325.The light output from the output optical member 325 may be visible to the eyes 330 of a user. Hereinafter, in the specification, the expression "display an object on a display" means that a light output from the display 321 is output via the output optical member 325, and the eyes 330 of user views the shape of an object via the light output via the output optical member 325. In addition, the expression "control a display so as to display an object" means that control is performed so that a light output from the display 321 is output via the output optical member 325, and enables the eyes 330 of the user to view the shape of an object via the light output via the output optical member 325.

A light 335 reflected from the eyes 330 of the user may meet the first splitter 341, may be incident to the eye tracking optical waveguide 342, may pass through the eye tracking optical waveguide 342, and may output to the eye tracking camera 310 by the second splitter 343.According to various embodiments, the light 335 reflected from the eyes 330 of the user may be a light that is output from the light emitting device 114-1 and 114-2 of FIG. 1, and is reflected by the eyes 330 of the user.According to various embodiments, the eye tracking camera 310 may be one or more second cameras 112-1 and 112-2 of FIG. 1.

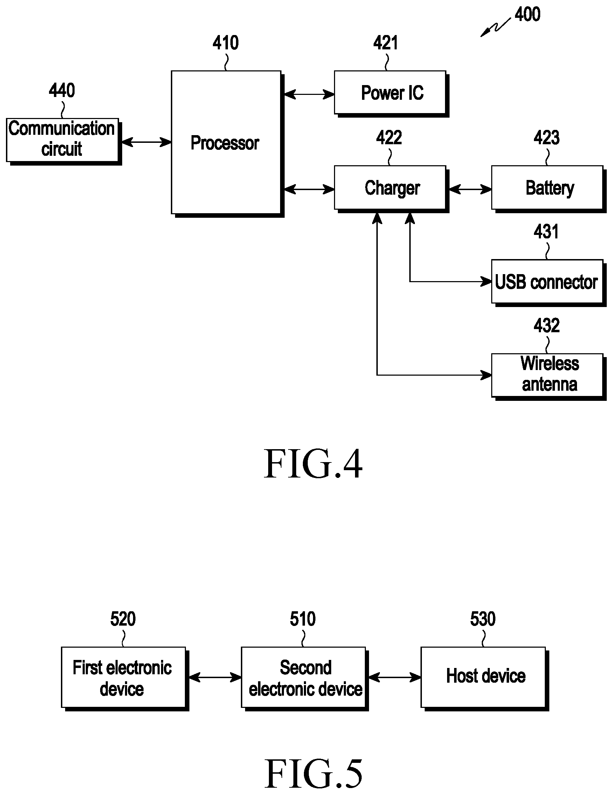

FIG. 4 is a block diagram of a first electronic device according to various embodiments. According to various embodiments, a second electronic device (e.g., the second electronic device 100 of FIG. 1) may be contained in the first electronic device 400.According to various embodiments, the first electronic device 400 may include a processor 410, a power IC 421, a charger 422, a battery 423, a USB connector 431, a wireless antenna 432, and a communication circuit 440.Without being limited to the drawing of FIG. 4, the first electronic device 400 may be embodied to further include more electronic elements (e.g., a display, a camera).

According to various embodiments, the processor 410 may control other elements of the first electronic device 400, the power IC 421, the charger 422, and the communication circuit 440, and may perform various data processing or operations.

According to various embodiments, the power IC 421 may convert power stored in the battery 423 to have a current or voltage that other elements of the first electronic device 400 require, and may supply the power to the other elements of the first electronic device 400.

According to various embodiments, the charger 422 may charge the battery 423 based on wireless power received via the wireless antenna 432 and/or an external power source connected via the USB connector 431.According to various embodiments, the USB connector 431 may connect an external power source and/or another electronic device to the first electronic device 400.According to various embodiments, the first electronic device 400 and the second electronic device 100 contained in the first electronic device 400 may be electrically connected via the USB connector 431.The USB connector 431 may include a plurality of connectors, and be configured so that one of the plurality of connectors is connected to the external power, and another connector is connected to another external electronic device (e.g., the second electronic device 400), but the disclose is not limited thereto.

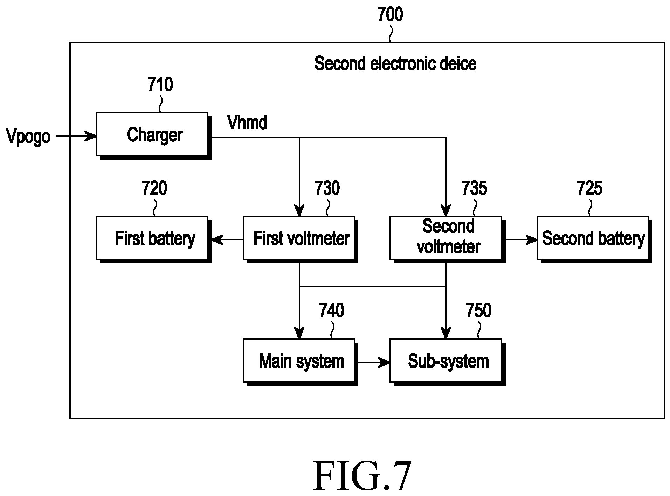

According to various embodiments, the communication circuit 440 may establish a wireless communication channel to another electronic device outside the first electronic device 400, and may support communication via the established communication channel.For example, the first electronic device 400 may receive information (e.g., the minimum voltage for operating a charger 710 of a second electronic device 700 of FIG. 7) associated with a second electronic device (e.g., the second electronic device 700 of FIG. 7) via the communication circuit 440.

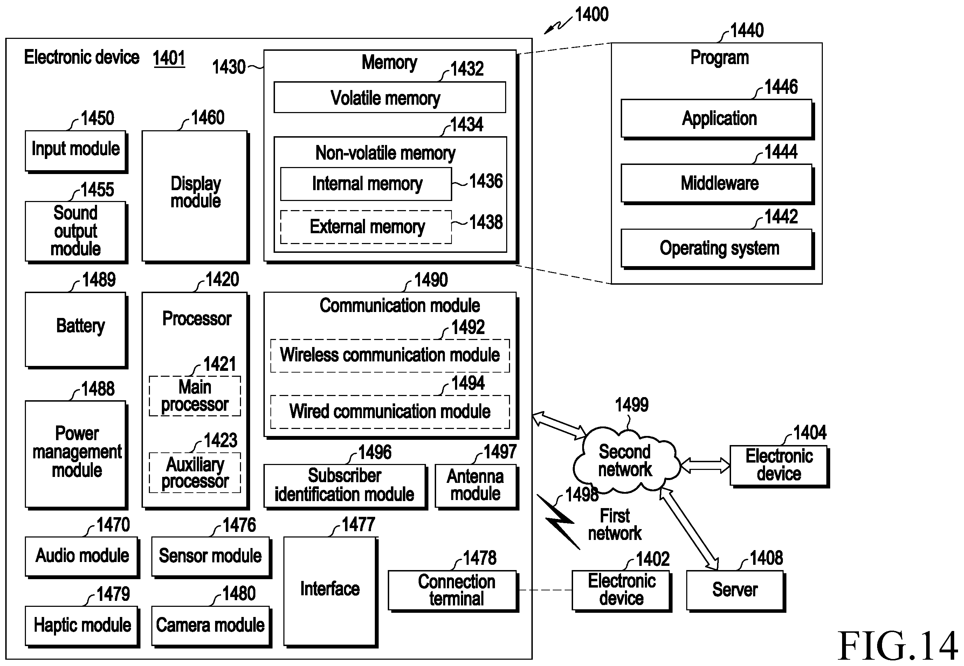

FIG. 5 is a diagram illustrating a connection among a first electronic device, a second electronic device charged by the first electronic device, and a host device according to various embodiment. According to various embodiments, a second electronic device 510 (e.g., the second electronic device 100 of FIG. 1) may perform communication with a first electronic device 520 (e.g., the first electronic device 400 of FIG. 4) and a host device 530 (e.g., an electronic device 1401 of FIG. 14).According to various embodiments, the second electronic device 510 may be accommodated in the first electronic device 520.

According to various embodiments, the first electronic device 520 may charge the second electronic device 510, when being connected to the second electronic device 510.According to various embodiments, the first electronic device 520 may communicate with the second electronic device 510, and may function as an assistant operation device that performs at least some of the operations performed by the second electronic device 510.According to various embodiments, the first electronic device 520 may communicate with the second electronic device 510 that communicates with the host device 530, and may function as an assistant operation device that performs at least some of the operations performed by the host device 530.

According to various embodiments, the second electronic device 510 may communicate with the host device 530, may receive information from the host device 530, and may operate based on the received information.

According to various embodiments, the host device 530 may be a device including a main processor such as a smart phone and/or a computer, or may be a network and/or a cloud.

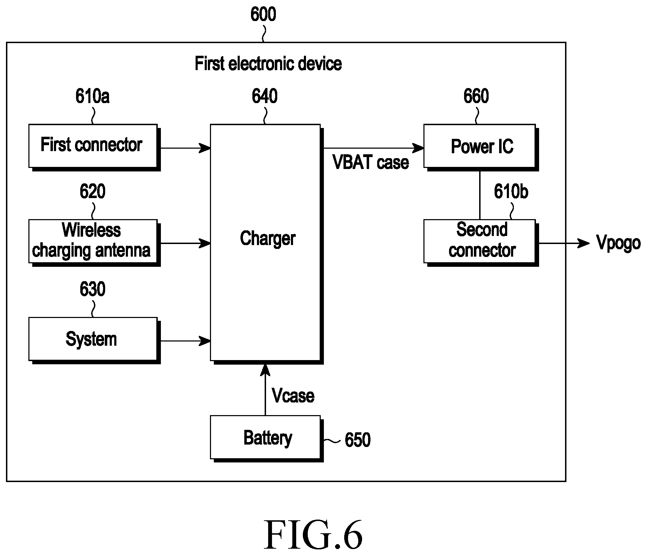

FIG. 6 is a block diagram of a first electronic device according to various embodiments. Referring to FIG. 6, a first electronic device 600 (e.g., the first electronic device 400 of FIG. 4) may include a first connector 610a and a second connector 610b (e.g., the USB connector 431 of FIG. 4), a wireless charging antenna 620, a system 630, a charger 640 (e.g., the charger 422 of FIG. 4), a battery 650 (e.g., the battery 423 of FIG. 4 and the power IC 660) (e.g., the power IC 421 of FIG. 4).

According to various embodiments, the first electronic device 600 may be connected to the outside via connectors (e.g., the first connector 610a or the second connector 610b).For example, the first electronic device 600 may be connected to an external power source via the first connector 610a.For example, the electronic device 600 may be connected to a second electronic device (e.g., a second electronic device 700 to be described with reference to FIG. 7) via the second connector 610b.For example, power (Vpogo) output from the power IC 660 may be transferred to an external electronic device (e.g., the second electronic device) via the second connector 610b.

According to various embodiments, the first electronic device 600 may receive wireless power from an external electronic device via the wireless charging antenna 620, or may supply wireless power to an external electronic device.

According to various embodiments, the system 630 may include various elements that receive power supplied from the battery 650 via the charger 640.For example, the system 630 may include at least one processor (e.g., the processor 410 of FIG. 4, a display module (not illustrated), and/or a memory (not illustrated).

According to various embodiments, the charger 640 may charge the battery 650 using power supplied from an external electronic device or an external power source via the first connector 610a and/or power supplied from an external electronic device via the wireless charging antenna 620.According to various embodiments, the charger 640 may supply power to an external electronic device (e.g., the second electronic device 700 of FIG. 7) using the power of the battery 650.The charger 640 may supply a voltage (V_{BATcase}) to the power IC 660 based on the voltage (V_{case}) of the battery 650.

According to various embodiments, the power IC 660 may convert a voltage (V_{BATcase}) output from the charger 640 into a voltage (V_{pogo}) to be output to the second electronic device 700.According to various embodiments, the first electronic device 600 (e.g., at least one processor (e.g., the processor 410 of FIG. 4)) may be connected to the second electronic device 700 via the second connector 610b that is connected to the power IC 660, and may control the power IC 660 so as to supply power (Vpogo) to the second electronic device 700 via the second connector 610b in a wired manner, thereby charging the batteries 720 and 725 of the second electronic device 700.

FIG. 7 is a block diagram of a second electronic device that is charged by a first electronic device according to various embodiments. Referring to FIG. 7, the second electronic device 700 may include a charger 710, a first voltmeter 730, a second voltmeter 735, a first battery 720, a second battery 725, a main system 740, and a sub-system 750.

According to various embodiments, the second electronic device 700 may include a connector (not illustrated) to be connected to the first electronic device 600, and may receive power having a voltage (V_{pogo}) supplied from the first electronic device 600 when being connected to the first electronic device 600 via the connector.

According to various embodiments, the charger 710 may convert a voltage (V_{pogo}) input from the first electronic device 600 into an output voltage (V_{hmd}).According to various embodiments, the voltage (V_{hmd}) output from the charger 710 may go through the first voltmeter 730 and the second voltmeter 735, and may be supplied to the first battery 720 and the second battery 725, respectively. The first voltmeter 730 and the second voltmeter 735 may be used for identifying the voltage of the first battery 720 and the voltage of the second battery 725, respectively. Information associated with the voltage of the first battery 720 and the voltage of the second battery 725 identified by the first voltmeter 730 and the second voltmeter 735 may be transferred to the main system 740 and the sub-system 750.

Although FIG. 7 illustrates that the second electronic device 700 includes two batteries and two voltmeters, according to various embodiments, the number of batteries and voltmeters capable of being contained in the second electronic device 700 is not limited thereto.

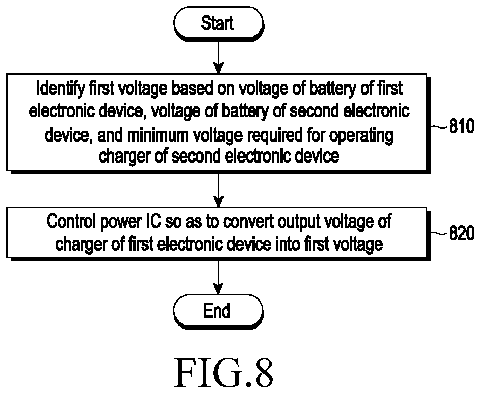

FIG. 8 is a flowchart illustrating operations performed by a first electronic device according to various embodiments. Hereinafter, although description will be provided with reference to elements of the first electronic device 600 of FIG. 6, according to various embodiments, a first electronic device that performs operations of FIG. 8 is not limited to the first electronic device 600 of FIG. 6, and operations of FIG. 8 may be performed by the first electronic device 400 of FIG. 4.

In operation 810, at least one processor (e.g., the processor 410) of the first electronic device (e.g., the first electronic device 600) may identify a first voltage based on the voltage of the battery 650 of the first electronic device 600, the voltage of the firstbattery 720 and the voltage of the second battery725 of the second electronic device 700, and the minimum voltage required for operating the charger 710 of the second electronic device 700.According to various embodiments, the at least one processor (e.g., the processor 410) may periodically receive information related to the voltage of the first battery 720 and the voltage of the second battery725 from the second electronic device 700 via a communication circuit (e.g., the communication circuit 440).According to various embodiments, the second electronic device 700 may inform the first electronic device 600 of the output voltage (V_{hmd}) of the charger 710 as the voltage of the first battery 720 and the voltage of the second battery 725.According to various embodiments, the at least one processor (e.g., the processor 410) may receive information related to the minimum voltage required for operating the charger 710 of the second electronic device 700 from the second electronic device 700 via a communication circuit (e.g., the communication circuit 440).

According to various embodiments, the at least one processor (e.g., the processor 410) of the first electronic device (e.g., the first electronic device 600) may identify the first voltage based on whether the voltage of the battery 650 of the first electronic device 600 exceeds the minimum voltage required for operating the charger 710 of the second electronic device 700.According to various embodiments, the at least one processor (e.g., the processor 410) of the first electronic device (e.g., the first electronic device 600) may identify the first voltage based on whether the voltage of the battery 650 of the first electronic device 600 exceeds the voltage of the first battery 720 and the voltage of the second battery 725 of the second electronic device 700.According to various embodiments, the at least one processor (e.g., the processor 410) of the first electronic device (e.g., the first electronic device 600) may identify the first voltage based on whether the voltage of the battery 650 of the first electronic device 600 exceeds a value obtained by adding a prespecified first reference voltage to the voltage of the first battery 720 and the voltage of the second battery 725 of the second electronic device 700.According to various embodiments, the at least one processor (e.g., the processor 410) of the first electronic device (e.g., the first electronic device 600) may identify the first voltage based on whether the average value of the voltage of the battery 650 of the first electronic device 600, and the voltage of the firstbattery 720 and the voltage of the second battery 725 of the second electronic device 700 exceeds the minimum voltage required for operating the charger 710 of the second electronic device 700.

According to various embodiments, the at least one processor (e.g., the processor 410) of the first electronic device (e.g., the first electronic device 600) may identify a prespecified first constant voltage as the first voltage. According to various embodiments, the at least one processor (e.g., the processor 410) of the first electronic device (e.g., the first electronic device 600) may identify, as the first voltage, a value obtained by adding a prespecified second reference voltage to a higher voltage between the voltage of the battery 650 of the first electronic device 600 and the voltage of the firstbattery 720 and the voltage of the second battery 725 of the second electronic device 700.According to various embodiments, the at least one processor (e.g., the processor 410) of the first electronic device (e.g., the first electronic device 600) may identify, as the first voltage, the average value of the voltage of the battery 650 of the first electronic device 600 and the voltage of the firstbattery 720 and the voltage of the second battery 725 of the second electronic device 700.According to various embodiments, the at least one processor (e.g., the processor 410) of the first electronic device (e.g., the first electronic device 600) may identify the minimum voltage for operating the charger 710 of the second electronic device 700 as the first voltage.

In operation 820, the at least one processor (e.g., the processor 410) of the first electronic device (e.g., the first electronic device 600) may control the power IC 660 so as to convert the output voltage of the charger 640 of the first electronic device 600 into the first voltage identified in operation 810.According to various embodiments, the power IC 660 may supply, to the second electronic device 700, power having the first voltage (V_{pogo}) obtained via conversion.

FIS. 9A and 9B are flowcharts illustrating operations performed by a first electronic device according to various embodiments. Hereinafter, although description will be provided with reference to elements of the first electronic device 600 of FIG. 6, according to various embodiments, a first electronic device that performs operations of FIS. 9A and 9B is not limited to the first electronic device 600 of FIG. 6, and operations of FIS. 9A and 9B may be performed by the first electronic device 400 of FIG. 4.

In operation 910, at least one processor (e.g., the processor 410) of a first electronic device (e.g., the first electronic device 600) may identify that a second electronic device 700 is being charged by the first electronic device 600.

In operation 911, the at least one processor (e.g., the processor 410) of the first electronic device (e.g., the first electronic device 600) may identify whether the first electronic device 600 is being charged by an external power source.

If it is identified that the first electronic device 600 is being charged by an external power source in operation 911, the at least one processor (e.g., the processor 410) of the first electronic device (e.g., the first electronic device 600) may identify whether the state of charge of the first electronic device 600 is in a constant voltage (CV) section in operation 920.According to various embodiments, the CV section may refer to the state in which the first electronic device 600 is almost completely charged, and the battery 650 of the first electronic device 600 constantly maintains a prespecified constant voltage. The prespecified constant voltage may be, for example, 4.4 V.

If it is identified that the first electronic device 600 is not being charged by an external power source in operation 911, the at least one processor (e.g., the processor 410) of the first electronic device (e.g., the first electronic device 600) may proceed with operation 930 described later.

If it is identified that the state of charge of the first electronic device 600 is in the CV section in operation 920, the at least one processor (e.g., the processor 410) of the first electronic device (e.g., the first electronic device 600) may set the output voltage (V_{pogo}) of the power IC 660 of the first electronic device 600 to a prespecified first voltage in operation 971.For example, the prespecified first voltage may be 5V.

If it is identified that the state of charge of the first electronic device 600 is not in the CV section in operation 920, the at least one processor (e.g., the processor 410) of the first electronic device (e.g., the first electronic device 600) may proceed with operation 930. In operation 930, the at least one processor (e.g., the processor 410) of the first electronic device 600 may identify whether the voltage (V_{case}) of the battery 650 of the first electronic device 600 exceeds the minimum voltage (Vᵤᵥₗₒ) required for operating the charger 710 of the second electronic device 700.According to various embodiments, the at least one processor (e.g., the processor 410) of the first electronic device 600 may receive information associated with the minimum voltage (Vᵤᵥₗₒ) for operating the charger 710 of the second electronic device 700 from the second electronic device 700.

If it is identified that the voltage (V_{case}) of the battery 650 of the first electronic device 600 is less than or equal to the minimum voltage (Vᵤᵥₗₒ) required for operating the charger 710 of the second electronic device 700 in operation 930, the at least one processor (e.g., the processor 410) of the first electronic device 600 may proceed with operation 972.In operation 972, the at least one processor (e.g., the processor 410) of the first electronic device 600 may control the power IC 660 of the first electronic device 600 so as to operate in a boost mode. According to various embodiments, if the power IC 660 is in the boost mode, a voltage (V_{pogo}) output from the power IC 660 may be a value obtained by adding a prespecified second reference voltage to a higher value between the voltage (V_{case}) of the battery 650 of the first electronic device 600 and the output voltage (V_{hmd}) of the charger 710 of the second electronic device 700.The second reference voltage may be, for example, 0.2V.According to various embodiments, the at least one processor (e.g., the processor 410) of the first electronic device 600 may receive information associated with the output voltage (V_{hmd}) of the charger 710 of the second electronic device 700 from the second electronic device 700.

If it is identified that the voltage (V_{case}) of the battery 650 of the first electronic device 600 exceeds the minimum voltage (Vᵤᵥₗₒ) required for operating the charger 710 of the second electronic device 700 in operation 930, the at least one processor (e.g., the processor 410) of the first electronic device 600 may proceed with operation 940.In operation 940, the at least one processor (e.g., the processor 410) of the first electronic device 600 may identify whether the out voltage (V_{hmd}) of the charger 710 of the second electronic device 700 is less than the voltage (V_{case}) of the battery 650 of the first electronic device 600.According to various embodiments, the at least one processor (e.g., the processor 410) of the first electronic device 600 may receive information associated with the output voltage (V_{hmd}) of the charger 710 of the second electronic device 700 from the second electronic device 700.

If it is identified that the out voltage (V_{hmd}) of the charger 710 of the second electronic device 700 is greater than or equal to the voltage (V_{case}) of the battery 650 of the first electronic device 600 in operation 940, the at least one processor (e.g., the processor 410) of the first electronic device 600 may proceed with operation 972 that has been described above.

If it is identified that the out voltage (V_{hmd}) of the charger 710 of the second electronic device 700 is less than the voltage (V_{case}) of the battery 650 of the first electronic device 600 in operation 940, the at least one processor (e.g., the processor 410) of the first electronic device 600 may proceed with operation 950.In operation 950, the at least one processor (e.g., the processor 410) of the first electronic device 600 may identify whether the voltage of the battery 650 of the first electronic device 600 exceeds a value obtained by adding a first reference voltage to the out voltage (V_{hmd}) of the charger 710 of the second electronic device 700.The first reference voltage may be, for example, 0.3V.

If it is identified that the voltage (V_{case}) of the battery 650 of the first electronic device 600 is less than or equal to a value obtained by adding the first reference voltage to the output voltage (V_{hmd}) of the charger 710 of the second electronic device 700 in operation 950, the at least one processor (e.g., the processor 410) of the first electronic device 600 may proceed with operation 972.

If it is identified that the voltage of the battery 650 of the first electronic device 600 exceeds a value obtained by adding the first reference voltage to the output voltage (V_{hmd}) of the charger 710 of the second electronic device 700 in operation 950, the at least one processor (e.g., the processor 410) of the first electronic device 600 may proceed with operation 960.In operation 960, the at least one processor (e.g., the processor 410) of the first electronic device 600 may identify whether the average value of the voltage (V_{case}) of the battery 650 of the first electronic device 600 and the output voltage (V_{hmd}) of the charger 710 of the second electronic device 700 exceeds the minimum voltage (Vᵤᵥₗₒ) required for operating the charger 710 of the second electronic device 700.

If it is identified that the average value of the voltage (V_{case}) of the battery 650 of the first electronic device 600 and the output voltage (V_{hmd}) of the charger 710 of the second electronic device 700 exceeds the minimum voltage (Vᵤᵥₗₒ) required for operating the charger 710 of the second electronic device 700 in operation 960, the at least one processor (e.g., the processor 410) of the first electronic device 600 may proceed with operation 973.In operation 973, the at least one processor (e.g., the processor 410) of the first electronic device 600 may control the power IC 660 of the first electronic device 600 so as to operate in a buck mode in which the output voltage (V_{pogo}) of the power IC 660 of the first electronic device 600 is the average value of the voltage (V_{case}) of the battery 650 of the first electronic device 600 and the output voltage (V_{hmd}) of the charger 710 of the second electronic device 700.

If it is identified that the average value of the voltage (V_{case}) of the battery 650 of the first electronic device 600 and the output voltage (V_{hmd}) of the charger 710 of the second electronic device 700 is less than or equal to the minimum voltage (Vᵤᵥₗₒ) required for operating the charger 710 of the second electronic device 700 in operation 960, the at least one processor (e.g., the processor 410) of the first electronic device 600 may proceed with operation 974.In operation 974, the at least one processor (e.g., the processor 410) of the first electronic device 600 may control the power IC 660 of the first electronic device 600 so as to operate in the buck mode in which the output voltage (V_{pogo}) of the power IC 660 of the first electronic device 600 is the minimum voltage (Vᵤᵥₗₒ) required for operating the charger 710 of the second electronic device 700.

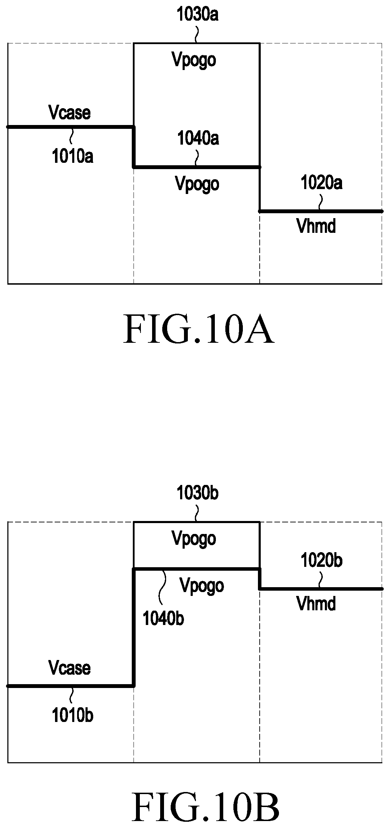

FIG. 10A is a diagram illustrating a voltage when a first electronic device according to various embodiments operates in a buck mode and a voltage in a comparative example. In FIG. 10A, V_{case}1010a illustrates the voltage level of the battery 650 of the first electronic device 600, and V_{hmd}1020a illustrates the output voltage level of the charger 710 of the second electronic device 700.V_{pogo} 1030a illustrates the input voltage of the power IC 660 of the first electronic device 600 according to the comparative example, and V_{pogo}1040a illustrates the input voltage of the power IC 660 of the first electronic device 600 according to various embodiments.

Referring to FIG. 10A, according to the comparative example, the power IC of the first electronic device may regularly output high V_{pogo}1030a, irrespective of V_{case}1010a and V_{hmd}1020a.Conversely, the power IC 660 of the first electronic device 600 according to various embodiments may output V_{pogo}1040a that is the average value of V_{case}1010a and V_{hmd}1020a.

FIG. 10B is a diagram illustrating a voltage when a first electronic device according to various embodiments operates in a boost mode and a voltage in a comparative example. In FIG. 10B, V_{case}1010b illustrates the voltage level of the battery 650 of the first electronic device 600, and V_{hmd}1020b illustrates the output voltage level of the charger 710 of the second electronic device 700.V_{pogo}1030b illustrates the input voltage of the power IC 660 of the first electronic device 600 according to the comparative example, and V_{pogo}1040b illustrates the input voltage of the power IC 660 of the first electronic device 600 according to various embodiments.

Referring to FIG. 10B, according to the comparative example, the power IC of the first electronic device may regularly output high V_{pogo}1030b, irrespective of V_{case}1010b and V_{hmd}1020b.Conversely, the power IC 660 of the first electronic device 600 according to various embodiments may output V_{pogo}1040b that is lower than V_{pogo}1030b and thus, charging efficiency may be improved when compared to the comparative example.In addition, a voltage input to the charger 710 of the second electronic device 700 is V_{pogo}1040b according to various embodiments, which is lower than V_{pogo}1030b, and thus, the efficiency of the charger 710 may be improved.

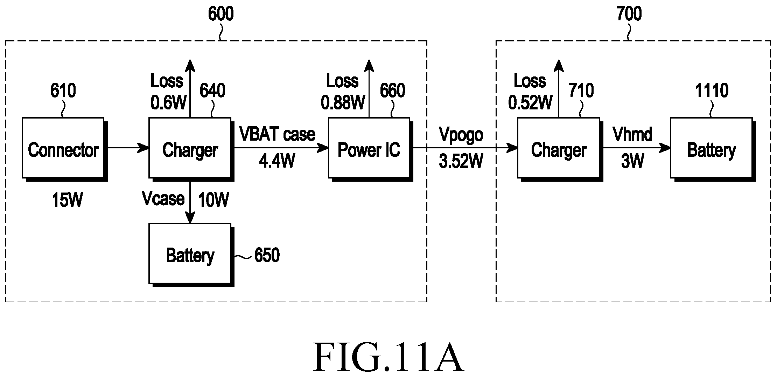

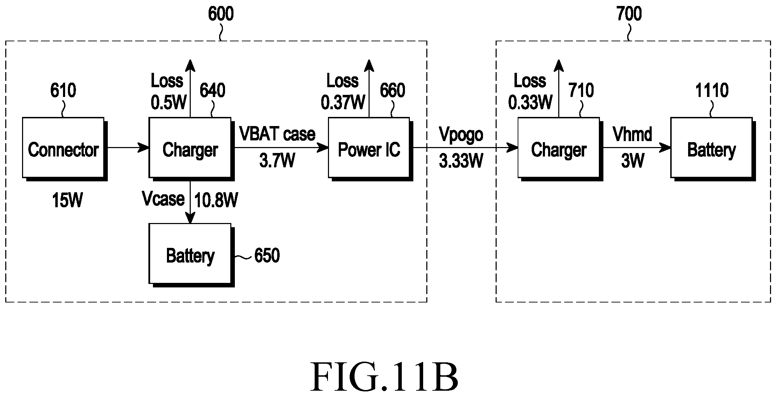

FIG. 11A is a diagram illustrating an example of charging efficiency according to a comparative example. FIG. 11B is a diagram illustrating an example of charging efficiency according to various embodiments.

Referring to FIG. 11A and 11B, power supplied from an external power source to the first electronic device 600 via the connector 610 may be equally 15W, and power supplied to a battery 1110 of the second electronic device 700 may be equally 3W.In

FIG. 11A, the efficiency of the power IC 660 is 80% and a power loss of 0.88W may occur at the power IC 660.In FIG. 11B, the efficiency of the power IC 660 is 90 % and a power loss of 0.37W may occur at the power IC 660.In FIG. 11A, the efficiency of the charger 710 is 85% and a power loss of 0.52W may occur at the charger 710.In FIG. 11B, the efficiency of the charger 710 is 90 % and a power loss of 0.33W may occur at the charger 710.In FIG. 11A, power supplied to the battery 650 of the first electronic device 600 is 10W.In FIG. 11B, power supplied to the battery 650 of the first electronic device 600 may be 10.8W.In other words, if a charging scheme according to various embodiments is used, the efficiency of the power IC 660 may be improved and the efficiency of the charger 710 is improved, when compared to the comparative example. Accordingly, a larger amount of power may be used for charging the battery 650 of the first electronic device 600, and thus, the battery 650 of the first electronic device 600 may be efficiently charged.

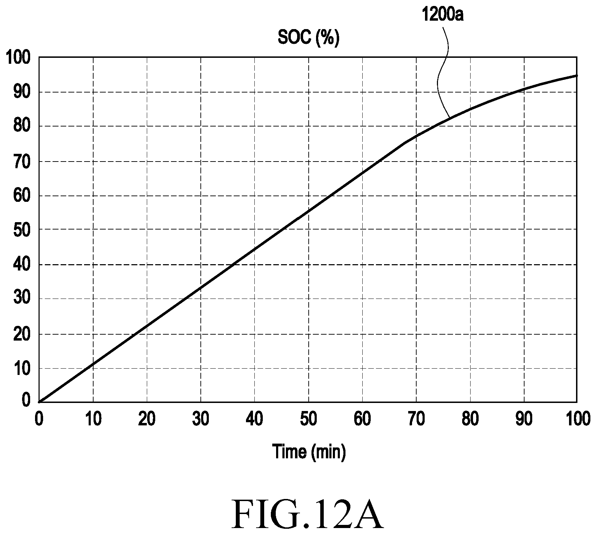

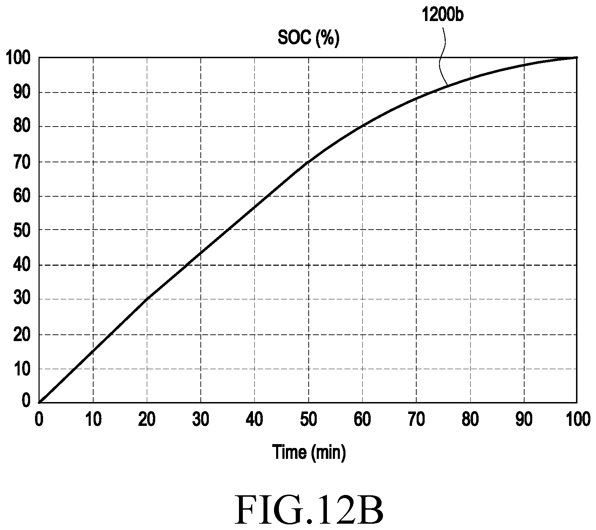

FIG. 12A illustrates an example of a charging curve associated with the battery 650 of the first electronic device 600 according to a comparative example. FIG. 12B illustrates an example of a charging curve associated with the battery 650 of the first electronic device 600 according to various embodiments. A curve 1200a of FIG. 12A is the graph of a state of charge (SOC) of the battery 650 of the first electronic device 600 over time when charging is performed according to a comparative example.A curve 1200b of FIG. 12B is the graph of an SOC of the battery 650 of the first electronic device 600 over time when charging is performed according to various embodiments. Referring to the curve 1200a of FIG. 12A, the battery 650 of the first electronic device 600 may be charged up to approximately 95% even when a time elapses 100 minutes. Conversely, referring to the curve 1200b of FIG. 12B, if the first electronic device 600 controls the power IC 660 based on the voltage of the battery 650 of the first electronic device 600, the first voltage of the battery 720 and the voltage of the second battery725 of the second electronic device 700, and the minimum voltage of the charger 710 of the second electronic device 700, the battery 650 of the first electronic device 600 may be charged (or fully charged) up to approximately 100% when a charging time elapses 100 minutes.

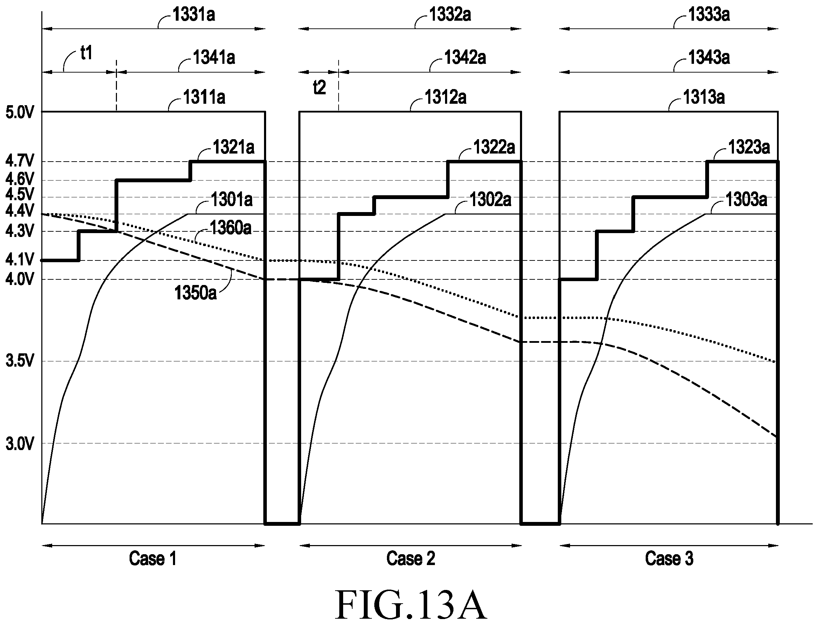

FIG. 13A is a diagram illustrating an example of charging curves according to a comparative example and various embodiments, in the state in which the first electronic device 600 does not receive power supplied from another electronic device and charges the second electronic device 700. Particularly, FIG. 13A illustrates curves of various parameters in a scenario of charging the second electronic device 700 three times while consuming the battery 650 of the first electronic device 600.

Referring to FIG. 13A, the first electronic device 600 according to a comparative example may operate in a boost mode during a period 1331a in which a first charging is performed, a period 1332a in which a second charging is performed, and a period 1333a in which a third charging is performed. Conversely, the first electronic device 600 according to various embodiments may operate in a buck mode in a section (or a time interval) (t1) in the period 1331a in which the first charging is performed, and may operate in a boost mode in the other section 1341a.The first electronic device 600 according to various embodiments may operate in the buck mode in a section (t2) in the period 1332a in which the second charging is performed, and may operate in the boost mode in the other section 1342a.The first electronic device 600 according to various embodiments may operate in the boost mode in an entire section 1343a of the period 1333a in which the third charging is performed.

In FIG. 13A, curves 1311a, 1312a, and 1313a illustrate the output voltages of the power IC of the first electronic device 600 according to the comparative example, and curves 1321a, 1322a, and 1323a illustrate the output voltages of the power IC of the first electronic device 600 according to various embodiments.In FIG. 13A, a curve 1350a illustrates the voltage of the battery of the first electronic device 600 according to the comparative example, and a curve 1360a illustrates the voltage of the battery of the first electronic device 600 according to various embodiments. Curves 1301a, 1302a, 1303a illustrate the voltages of the battery of the second electronic device 700.

Referring to FIG. 13A, while the voltage of the battery of the second electronic device 700 is increased equally, the output voltage of the power IC of the first electronic device 500 according to the comparative example is constantly maintained as a high value. Conversely, the output voltage of the power IC of the first electronic device 600 according to various embodiments may vary over time within a range of values lower than the output voltage of the power IC of the first electronic device 600 according to the comparative example. Accordingly, by comparing the curve 1350a and the curve 1360a, it is identified that the curve 1360a is higher than the curve 1350a while the voltage of the battery of the second electronic device 700 is increased equally.In other words, the first electronic device 600 according to various embodiments may charge the second electronic device 700 with a higher efficiency when compared to the comparative example.

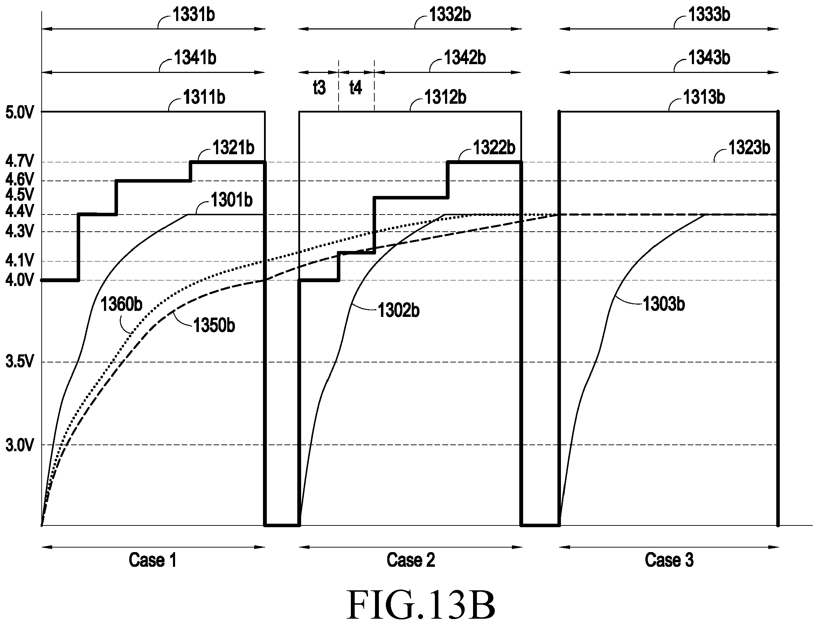

FIG. 13B is a diagram illustrating an example of charging curves according to a comparative example and various embodiments, in the state in which the first electronic device 600 receives power supplied from another electronic device and charges the second electronic device 700. Particularly, FIG. 13B illustrates curves of various parameters in a scenario in which the first electronic device 600 charges the second electronic device 700 three times while receiving power supplied from another electronic device.

Referring to FIG. 13B, the first electronic device 600 according to a comparative example may operate in a boost mode during a period 1331b in which a first charging is performed, a period 1332b in which a second charging is performed, and a period 1333b in which a third charging is performed. Conversely, the first electronic device 600 according to various embodiments may operate in the boost mode in an entire section 1341b of the period 1331b in which the first charging is performed. The first electronic device 600 according to various embodiments may operate in a buck mode in which the output voltage (V_{pogo}) of the power IC 660 of the first electronic device 600 is the minimum voltage (Vᵤᵥₗₒ) for operating the charger 710 of the second electronic device 700 in a section (t3) of the period 1332b in which the second charging is performed, may operate in a buck mode in which the output voltage (V_{pogo}) of the power IC 660 of the first electronic device 600 is the average value of the voltage (V_{case}) of the battery 650 of the first electronic device 600 and the output voltage (V_{hmd}) of the charger 710 of the second electronic device 700 in a section (t4), and may operate in the boost mode in the remaining section 1342b.The first electronic device 600 according to various embodiments may operate in a boost mode in which the output voltage (Vpogo) of the power IC 660 of the first electronic device 600 is a prespecified first voltage during an entire section 1343b in the period 1333b in which the third charging is performed.

In FIG. 13B, curves 1311b, 1312b, and 1313b illustrate the output voltages of the power IC 660 of the first electronic device 600 according to the comparative example, and curves 1321b, 1322b, and 1323b illustrate the output voltages of the power IC 660 of the first electronic device 600 according to various embodiments.In FIG. 13B, a curve 1350b illustrates the voltage of the battery 650 of the first electronic device 600 according to the comparative example, and a curve 1360b illustrates the voltage of the battery 650 of the first electronic device 600 according to various embodiments. Curves 1301b, 1302b, and 1303b illustrate the voltage of the first battery 720 and the voltage of the second battery725 of the second electronic device 700.

Referring to FIG. 13B, while the voltage of the first battery 720 and the voltage of the second battery725 of the second electronic device 700 is equally increased, the output voltage of the power IC 660 of the first electronic device 600 according to the comparative example is constantly maintained as a high value. Conversely, the output voltage of the power IC 660 of the first electronic device 600 according to various embodiments may vary over time within a range of values lower than the output voltage of the power IC 660 of the first electronic device 600 according to the comparative example. Accordingly, by comparing the curve 1350b and the curve 1360b, it is identified that the curve 1360b is higher than the curve 1350b while the voltage of the first battery 720 and the voltage of the second battery725 of the second electronic device 700 is equally increased.In other words, the first electronic device 600 according to various embodiments may charge the second electronic device 700 with a higher efficiency when compared to the comparative example.

FIG. 14 is a block diagram illustrating an electronic device 1401 (e.g., the host device 530 of FIG. 5) in a network environment 1400 according to various embodiments. Referring to FIG. 14, the electronic device 1401 in the network environment 1400 may communicate with an electronic device 1402 via a first network 1498 (e.g., a short-range wireless communication network), or at least one of an electronic device 1404 or a server 1408 via a second network 1499 (e.g., a long-range wireless communication network). According to an embodiment, the electronic device 1401 may communicate with the electronic device 1404 via the server 1408.According to an embodiment, the electronic device 1401 may include a processor 1420, memory 1430, an input module 1450, a sound output module 1455, a display module 1460, an audio module 1470, a sensor module 1476, an interface 1477, a connecting terminal 1478, a haptic module 1479, a camera module 1480, a power management module 1488, a battery 1489, a communication module 1490, a subscriber identification module (SIM) 1496, or an antenna module 1497.In some embodiments, at least one of the components (e.g., the connecting terminal 1478) may be omitted from the electronic device 1401, or one or more other components may be added in the electronic device 1401.In some embodiments, some of the components (e.g., the sensor module 1476, the camera module 1480, or the antenna module 1497) may be implemented as a single component (e.g., the display module 1460).

The processor 1420 may execute, for example, software (e.g., a program 1440) to control at least one other component (e.g., a hardware or software component) of the electronic device 1401 coupled with the processor 1420, and may perform various data processing or computation. According to one embodiment, as at least part of the data processing or computation, the processor 1420 may store a command or data received from another component (e.g., the sensor module 1476 or the communication module 1490) in volatile memory 1432, process the command or the data stored in the volatile memory 1432, and store resulting data in non-volatile memory 1434.According to an embodiment, the processor 1420 may include a main processor 1421 (e.g., a central processing unit (CPU) or an application processor (AP)), or an auxiliary processor 1423 (e.g., a graphics processing unit (GPU), a neural processing unit (NPU), an image signal processor (ISP), a sensor hub processor, or a communication processor (CP)) that is operable independently from, or in conjunction with, the main processor 1421.For example, when the electronic device 1401 includes the main processor 1421 and the auxiliary processor 1423, the auxiliary processor 1423 may be adapted to consume less power than the main processor 1421, or to be specific to a specified function. The auxiliary processor 1423 may be implemented as separate from, or as part of the main processor 1421.

The auxiliary processor 1423 may control, for example, at least some of functions or states related to at least one component (e.g., the display module 1460, the sensor module 1476, or the communication module 1490) among the components of the electronic device 1401, instead of the main processor 1421 while the main processor 1421 is in an inactive (e.g., sleep) state, or together with the main processor 1421 while the main processor 1421 is in an active (e.g., executing an application) state.According to an embodiment, the auxiliary processor 1423 (e.g., an image signal processor or a communication processor) may be implemented as part of another component (e.g., the camera module 1480 or the communication module 1490) functionally related to the auxiliary processor 1423.According to an embodiment, the auxiliary processor 1423 (e.g., the neural processing unit) may include a hardware structure specified for artificial intelligence model processing.An artificial intelligence model may be generated by machine learning. Such learning may be performed, e.g., by the electronic device 1401 where the artificial intelligence model is performed or via a separate server (e.g., the server 1408).Learning algorithms may include, but are not limited to, e.g., supervised learning, unsupervised learning, semi-supervised learning, or reinforcement learning. The artificial intelligence model may include a plurality of artificial neural network layers.The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1430 may store various data used by at least one component (e.g., the processor 1420 or the sensor module 1476) of the electronic device 1401.The various data may include, for example, software (e.g., the program 1440) and input data or output data for a command related thereto. The memory 1430 may include the volatile memory 1432 or the non-volatile memory 1434.

The program 1440 may be stored in the memory 1430 as software, and may include, for example, an operating system (OS) 1442, middleware 1444, or an application 1446.

The input module 1450 may receive a command or data to be used by another component (e.g., the processor 1420) of the electronic device 1401, from the outside (e.g., a user) of the electronic device 1401.The input module 1450 may include, for example, a microphone, a mouse, a keyboard, a key (e.g., a button), or a digital pen (e.g., a stylus pen).

The sound output module 1455 may output sound signals to the outside of the electronic device 1401.The sound output module 1455 may include, for example, a speaker or a receiver. The speaker may be used for general purposes, such as playing multimedia or playing record. The receiver may be used for receiving incoming calls.According to an embodiment, the receiver may be implemented as separate from, or as part of the speaker.

The display module 1460 may visually provide information to the outside (e.g., a user) of the electronic device 1401.The display module 1460 may include, for example, a display, a hologram device, or a projector and control circuitry to control a corresponding one of the display, hologram device, and projector. According to an embodiment, the display module 1460 may include a touch sensor adapted to detect a touch, or a pressure sensor adapted to measure the intensity of force incurred by the touch.

The audio module 1470 may convert a sound into an electrical signal and vice versa. According to an embodiment, the audio module 1470 may obtain the sound via the input module 1450, or output the sound via the sound output module 1455 or an external electronic device (e.g., an electronic device 1402 (e.g., a speaker or a headphone)) directly or wirelessly coupled with the electronic device 1401.

The sensor module 1476 may detect an operational state (e.g., power or temperature) of the electronic device 1401 or an environmental state (e.g., a state of a user) external to the electronic device 1401, and then generate an electrical signal or data value corresponding to the detected state.According to an embodiment, the sensor module 1476 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1477 may support one or more specified protocols to be used for the electronic device 1401 to be coupled with the external electronic device (e.g., the electronic device 1402) directly or wirelessly.According to an embodiment, the interface 1477 may include, for example, a high definition multimedia interface (HDMI), a universal serial bus (USB) interface, a secure digital (SD) card interface, or an audio interface.

A connecting terminal 1478 may include a connector via which the electronic device 1401 may be physically connected with the external electronic device (e.g., the electronic device 1402).According to an embodiment, the connecting terminal 1478 may include, for example, an HDMI connector, a USB connector, an SD card connector, or an audio connector (e.g., a headphone connector).

The haptic module 1479 may convert an electrical signal into a mechanical stimulus (e.g., a vibration or a movement) or electrical stimulus which may be recognized by a user via his tactile sensation or kinesthetic sensation. According to an embodiment, the haptic module 1479 may include, for example, a motor, a piezoelectric element, or an electric stimulator.

The camera module 1480 may capture a still image or moving images. According to an embodiment, the camera module 1480 may include one or more lenses, image sensors, image signal processors, or flashes.

The power management module 1488 may manage power supplied to the electronic device 1401.According to one embodiment, the power management module 1488 may be implemented as at least part of, for example, a power management integrated circuit (PMIC).

The battery 1489 may supply power to at least one component of the electronic device 1401.According to an embodiment, the battery 1489 may include, for example, a primary cell which is not rechargeable, a secondary cell which is rechargeable, or a fuel cell.

The communication module 1490 may support establishing a direct (e.g., wired) communication channel or a wireless communication channel between the electronic device 1401 and the external electronic device (e.g., the electronic device 1402, the electronic device 1404, or the server 1408) and performing communication via the established communication channel. The communication module 1490 may include one or more communication processors that are operable independently from the processor 1420 (e.g., the application processor (AP)) and supports a direct (e.g., wired) communication or a wireless communication.According to an embodiment, the communication module 1490 may include a wireless communication module 1492 (e.g., a cellular communication module, a short-range wireless communication module, or a global navigation satellite system (GNSS) communication module) or a wired communication module 1494 (e.g., a local area network (LAN) communication module or a power line communication (PLC) module).A corresponding one of these communication modules may communicate with the external electronic device 1404 via the first network 1498 (e.g., a short-range communication network, such as BluetoothTM, wireless-fidelity (Wi-Fi) direct, or infrared data association (IrDA)) or the second network 1499 (e.g., a long-range communication network, such as a legacy cellular network, a 5G network, a next-generation communication network, the Internet, or a computer network (e.g., LAN or wide area network (WAN)).These various types of communication modules may be implemented as a single component (e.g., a single chip), or may be implemented as multi components (e.g., multi chips) separate from each other.The wireless communication module 1492 may identify or authenticate the electronic device 1401 in a communication network, such as the first network 1498 or the second network 1499, using subscriber information (e.g., international mobile subscriber identity (IMSI)) stored in the subscriber identification module 1496.

The wireless communication module 1492 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC).The wireless communication module 1492 may support a high-frequency band (e.g., the mmWave band) to achieve, e.g., a high data transmission rate.The wireless communication module 1492 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1492 may support various requirements specified in the electronic device 1401, an external electronic device (e.g., the electronic device 1404), or a network system (e.g., the second network 1499).According to an embodiment, the wireless communication module 1492 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 1497 may transmit or receive a signal or power to or from the outside (e.g., the external electronic device) of the electronic device 1401.According to an embodiment, the antenna module 1497 may include an antenna including a radiating element composed of a conductive material or a conductive pattern formed in or on a substrate (e.g., a printed circuit board (PCB)).According to an embodiment, the antenna module 1497 may include a plurality of antennas (e.g., array antennas).In such a case, at least one antenna appropriate for a communication scheme used in the communication network, such as the first network 1498 or the second network 1499, may be selected, for example, by the communication module 1490 from the plurality of antennas. The signal or the power may then be transmitted or received between the communication module 1490 and the external electronic device via the selected at least one antenna. According to an embodiment, another component (e.g., a radio frequency integrated circuit (RFIC)) other than the radiating element may be additionally formed as part of the antenna module 1497.

According to various embodiments, the antenna module 1497 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1401 and the external electronic device 1404 via the server 1408 coupled with the second network 1499.Each of the external electronic devices 1402 or 1404 may be a device of a same type as, or a different type, from the electronic device 1401.According to an embodiment, all or some of operations to be executed at the electronic device 1401 may be executed at one or more of the external electronic devices 1402, 1404, or 1408.For example, if the electronic device 1401 should perform a function or a service automatically, or in response to a request from a user or another device, the electronic device 1401, instead of, or in addition to, executing the function or the service, may request the one or more external electronic devices to perform at least part of the function or the service.The one or more external electronic devices receiving the request may perform the at least part of the function or the service requested, or an additional function or an additional service related to the request, and transfer an outcome of the performing to the electronic device 1401.The electronic device 1401 may provide the outcome, with or without further processing of the outcome, as at least part of a reply to the request.To that end, a cloud computing, distributed computing, mobile edge computing (MEC), or client-server computing technology may be used, for example. The electronic device 1401 may provide ultra low-latency services using, e.g., distributed computing or mobile edge computing.In another embodiment, the external electronic device 1404 may include an internet-of-things (IoT) device. The server 1408 may be an intelligent server using machine learning and/or a neural network.According to an embodiment, the external electronic device 1404 or the server 1408 may be included in the second network 1499.The electronic device 1401 may be applied to intelligent services (e.g., smart home, smart city, smart car, or healthcare) based on 5G communication technology or IoT-related technology.

It should be appreciated that various embodiments of the disclosure and the terms used therein are not intended to limit the technological features set forth herein to particular embodiments and include various changes, equivalents, or replacements for a corresponding embodiment.With regard to the description of the drawings, similar reference numerals may be used to refer to similar or related elements.It is to be understood that a singular form of a noun corresponding to an item may include one or more of the things, unless the relevant context clearly indicates otherwise.As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases.As used herein, such terms as "1st" and "2nd", or "first" and "second" may be used to simply distinguish a corresponding component from another, and does not limit the components in other aspect (e.g., importance or order).It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry".A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 340) including one or more instructions that are stored in a storage medium (e.g., internal memory 336 or external memory 338) that is readable by a machine (e.g., the electronic device 301).For example, a processor (e.g., the processor 320) of the machine (e.g., the electronic device 301) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

A first electronic device (e.g., the first electronic device 600 of FIG. 6) according to various embodiments (e.g., the first electronic device 600 of FIG. 6) (e.g., the second electronic device 700 of FIG. 7) may include a first battery (e.g., the battery 650 of FIG. 6), a first charger (e.g., the charger 640 of FIG. 6) electrically connected to the first battery (e.g., the battery 650 of FIG. 6), a power IC (e.g., the power IC 660 of FIG. 6)) connected to the first charger (e.g., the charger 640 of FIG. 6) and configured to convert an output voltage of the first charger (e.g., the charger 640 of FIG. 6), a connector (e.g., the second connector 610b of FIG. 6) electrically connected to the power IC (e.g., the power IC 660 of FIG. 6) and electrically connectable to a second electronic device (e.g., the second electronic device 700 of FIG. 7), and at least one processor (e.g., the processor 410 of FIG. 4), wherein the at least one processor (e.g., the processor 410 of FIG. 4) is configured to identify a first voltage based on the voltage of the first battery (e.g., the battery 650 of FIG. 6) of the first electronic device (e.g., the first electronic device 600 of FIG. 6), the output voltage of the second batteries 720 and 725 of the second electronic device (e.g., the second electronic device 700 of FIG. 7), and the minimum voltage required for operating the second charger 710 of the second electronic device (e.g., the second electronic device 700 of FIG. 7), and control the power IC (e.g., the power IC 660 of FIG. 6) to transfer a first power having the first voltage to the second electronic device (e.g., the second electronic device 700 of FIG. 7) via the connector (e.g., the second connector 610b of FIG. 6).

According to various embodiments, the first electronic device (e.g., the first electronic device 600 of FIG. 6) may further include the first connector 610a for connection with an external power source, and the at least one processor (e.g., the processor 410 of FIG. 4) is configured to identify whether power is supplied via the first connector 610a from the external power source, and to identify the first voltage based on whether the power is supplied via the first connector 610a from the external power source.

According to various embodiments, the at least one processor (e.g., the processor 410 of FIG. 4) is configured to identify whether a state of charge of the first electronic device (e.g., the first electronic device 600 of FIG. 6) is located in a constant voltage (CV) section, and to identify the first voltage based on whether the state of charge of the first electronic device (e.g., the first electronic device 600 of FIG. 6) is located in the CV section.

According to various embodiments, the at least one processor (e.g., the processor 410 of FIG. 4) is configured to identify, as the first voltage, a prespecified first constant voltage based on identifying that the state of charge of the first electronic device (e.g., the first electronic device 600 of FIG. 6) is in the CV section.

According to various embodiments, the at least one processor (e.g., the processor 410 of FIG. 4) is configured to identify whether the voltage of the first battery (e.g., the battery 650 of FIG. 6) of the first electronic device (e.g., the first electronic device 600 of FIG. 6) exceeds the minimum voltage required for operating the second charger 710 of the second electronic device (e.g., the second electronic device 700 of FIG. 7), and identify the first voltage based on whether the voltage of the first battery (e.g., the battery 650 of FIG. 6) of the first electronic device (e.g., the first electronic device 600 of FIG. 6) exceeds the minimum voltage required for operating the second charger 710 of the second electronic device (e.g., the second electronic device 700 of FIG. 7).

According to various embodiments, the at least one processor (e.g., the processor 410 of FIG. 4) is configured to identify the first voltage as a value higher than a higher voltage between the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7), based on identifying that the voltage of the first battery (e.g., the battery 650 of FIG. 6) of the first electronic device (e.g., the first electronic device 600 of FIG. 6) is less than or equal to the minimum voltage required for operating the second charger 710 of the second electronic device (e.g., the second electronic device 700 of FIG. 7).

According to various embodiments, the at least one processor (e.g., the processor 410 of FIG. 4) is configured to identify the voltage of the second battery (e.g., the batteries 720 and 725 of FIG. 7) of the second electronic device (e.g., the second electronic device 700 of FIG. 7), identify whether the voltage of the second battery (e.g., the batteries 720 and 725 of FIG. 7) of the second electronic device (e.g., the second electronic device 700 of FIG. 7) is less than the voltage of the first battery (e.g., the battery 650 of FIG. 6) of the first electronic device (e.g., the first electronic device 600 of FIG. 6), and identify the first voltage based on whether the voltage of the second battery (e.g., the batteries 720 and 725 of FIG. 7) of the second electronic device (e.g., the second electronic device 700 of FIG. 7) is less than the voltage of the first battery (e.g., the battery 650 of FIG. 6) of the first electronic device (e.g., the first electronic device 600 of FIG. 6).

According to various embodiments, the at least one processor is configured to identify the first voltage as a value higher than a higher voltage between the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7), based on identifying that the voltage of the second battery (e.g., the batteries 720 and 725 of FIG. 7) of the second electronic device (e.g., the second electronic device 700 of FIG. 7) is greater than or equal to the voltage of the first battery (e.g., the battery 650 of FIG. 6) of the first electronic device (e.g., the first electronic device 600 of FIG. 6).

According to various embodiments, the at least one processor (e.g., the processor 410 of FIG. 4) is configured to identify the voltage of the second battery (e.g., the batteries 720 and 725 of FIG. 7) of the second electronic device (e.g., the second electronic device 700 of FIG. 7), identify whether the voltage of the first battery (e.g., the battery 650 of FIG. 6) of the first electronic device (e.g., the first electronic device 600 of FIG. 6) exceeds a value obtained by adding a first reference voltage to the voltage of the second battery (e.g., the batteries 720 and 725 of FIG. 7) of the second electronic device (e.g., the second electronic device 700 of FIG. 7), and identify the first voltage based on whether the voltage of the first battery (e.g., the battery 650 of FIG. 6) of the first electronic device (e.g., the first electronic device 600 of FIG. 6) exceeds the value obtained by adding the first reference voltage to the voltage of the second battery (e.g., the batteries 720 and 725 of FIG. 7) of the second electronic device (e.g., the second electronic device 700 of FIG. 7).

According to various embodiments, the at least one processor (e.g., the processor 410 of FIG. 4) is configured to identify the first voltage as a value higher than a higher voltage between the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7), based on identifying that the voltage of the first battery (e.g., the battery 650 of FIG. 6) of the first electronic device (e.g., the first electronic device 600 of FIG. 6) is less than or equal to a value obtained by adding the first reference voltage to the voltage of the second battery (e.g., the batteries 720 and 725 of FIG. 7) of the second electronic device (e.g., the second electronic device 700 of FIG. 7).

According to various embodiments, the at least one processor (e.g., the processor 410 of FIG. 4) is configured to identify the voltage of the second battery (e.g., the batteries 720 and 725 of FIG. 7) of the second electronic device (e.g., the second electronic device 700 of FIG. 7), to identify whether the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7) exceeds the minimum voltage required for operating the second charger 710 of the second electronic device (e.g., the second electronic device 700 of FIG. 7), and identify the first voltage based on whether the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7) exceeds the minimum voltage required for operating the second charger 710 of the second electronic device (e.g., the second electronic device 700 of FIG. 7).

According to various embodiments, the at least one processor (e.g., the processor 410 of FIG. 4) is configured to identify the first voltage as the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7), based on identifying that the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7) exceeds the minimum voltage required for operating the second charger 710 of the second electronic device (e.g., the second electronic device 700 of FIG. 7).

According to various embodiments, the at least one processor (e.g., the processor 410 of FIG. 4) is configured to identify the first voltage as the minimum voltage required for operating the second charger 710 of the second electronic device (e.g., the second electronic device 700 of FIG. 7) based on identifying that the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the second electronic device 700 of FIG. 7) is less than or equal to the minimum voltage required for operating the second charger 710 of the second electronic device (e.g., the second electronic device 700 of FIG. 7).

According to various embodiments, a method performed in the first electronic device 600 configured to supply power to a second electronic device (e.g., the electronic device 700 of FIG. 7) may include an operation of identifying a first voltage based on the voltage of the first battery 650 of the first electronic device (e.g., the first electronic device 600 of FIG. 6), the voltage of a second battery (e.g., the batteries 720 and 725 of FIG. 7) of the second electronic device (e.g., the electronic device 700 of FIG. 7), and the minimum voltage required for operating a charger (e.g., the charger 710 of FIG. 7) of the second electronic device (e.g., the second electronic device 700 of FIG. 7), and an operation of controlling a power IC 660 to transfer power having the first voltage to the second electronic device (e.g., the electronic device 700 of FIG. 7).

According to various embodiments, the method may further include an operation of identifying whether the first electronic device (e.g., the first electronic device 600 of FIG. 6) is supplied with power from an external power source, and the operation of identifying the first voltage may include an operation of identifying the first voltage based on whether the power is supplied via the second connector 610 from the external power source.

According to various embodiments, the method may further include an operation of identifying whether a state of charge of the first electronic device (e.g., the first electronic device 600 of FIG. 6) is located in a constant voltage (CV) section, and the operation of identifying the first voltage may include an operation of identifying the first voltage based on whether the state of charge of the first electronic device (e.g., the first electronic device 600 of FIG. 6) is located in the CV section.

According to various embodiments, the method may further include an operation of identifying whether the voltage of the first battery (e.g., the battery 650 of FIG. 6) of the first electronic device (e.g., the first electronic device 600 of FIG. 6) exceeds the minimum voltage required for operating the charger (e.g., the charger 710 of FIG. 7) of the second electronic device (e.g., the electronic device 700 of FIG. 7), and the operation of identifying the first voltage may include an operation of identifying the first voltage based on whether the voltage of the first battery (e.g., the battery 650 of FIG. 6) of the first electronic device (e.g., the first electronic device 600 of FIG. 6) exceeds the minimum voltage required for operating the charger (e.g., the charger 710 of FIG. 7) of the second electronic device (e.g., the electronic device 700 of FIG. 7).

According to various embodiments, the method may further include an operation of identifying the voltage of the second battery (e.g., the batteries 720 and 725 of FIG. 7) (e.g., of the charger 710 of FIG. 7) of the second electronic device (e.g., the electronic device 700 of FIG. 7), and an operation of identifying whether the voltage of the second battery (e.g., the batteries 720 and 725 of FIG. 7) of the second electronic device (e.g., the electronic device 700 of FIG. 7) is less than the voltage of the first battery (e.g., the battery 650 of FIG. 6) of the first electronic device (e.g., the first electronic device 600 of FIG. 6), and the operation of identifying the first voltage may include an operation of identifying the first voltage based on whether the voltage of the second battery (e.g., the batteries 720 and 725 of FIG. 7) of the second electronic device (e.g., the electronic device 700 of FIG. 7) is less than the voltage of the first battery (e.g., the battery 650 of FIG. 6) of the first electronic device (e.g., the first electronic device 600 of FIG. 6).

According to various embodiments, the method may further include an operation of identifying whether the voltage of the first battery (e.g., the battery 650 of FIG. 6) of the first electronic device (e.g., the first electronic device 600 of FIG. 6) exceeds a value obtained by adding a first reference voltage to the voltage of the second battery (e.g., the batteries 720 and 725 of FIG. 7) of the second electronic device (e.g., the electronic device 700 of FIG. 7), and the operation of identifying the first voltage may include an operation of identifying the first voltage based on whether the voltage of the first battery (e.g., the battery 650 of FIG. 6) of the first electronic device (e.g., the first electronic device 600 of FIG. 6) exceeds the value obtained by adding the first reference voltage to the voltage of the second battery (e.g., the batteries 720 and 725 of FIG. 7) of the second electronic device (e.g., the electronic device 700 of FIG. 7).

According to various embodiments, the method may further include an operation of identifying the voltage of the second battery (e.g., the batteries 720 and 725 of FIG. 7) of the second electronic device (e.g., the electronic device 700 of FIG. 7), an operation of identifying whether the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the electronic device 700 of FIG. 7) exceeds the minimum voltage required for operating the charger (e.g., the charger 710 of FIG. 7) of the second electronic device (e.g., the electronic device 700 of FIG. 7), an operation of identifying the first voltage as the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the electronic device 700 of FIG. 7), based on identifying that the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the electronic device 700 of FIG. 7) exceeds the minimum voltage required for operating the charger (e.g., the charger 710 of FIG. 7) of the second electronic device (e.g., the electronic device 700 of FIG. 7), and an operation of identifying, as the first voltage, the minimum voltage required for operating the charger (e.g., the charger 710 of FIG. 7) of the second electronic device (e.g., the electronic device 700 of FIG. 7), based on identifying that the average value of the voltage of the first battery (e.g., the battery 650 of FIG. 6) of the first electronic device (e.g., the first electronic device 600 of FIG. 6) and the voltage of the second battery (e.g., the batteries 720 and 725 of FIG. 7) of the second electronic device (e.g., the electronic device 700 of FIG. 7) is less than or equal to the minimum voltage required for operating the charger (e.g., the charger 710 of FIG. 7) of the second electronic device (e.g., the electronic device 700 of FIG. 7).

## Claims

1. A first electronic device (600) comprising:
a first battery (650);
a first charger (640) electrically connected to the first battery (650);
a power integrated circuit (IC) (660) electrically connected to the first charger (640), and configured to convert an output voltage of the first charger (640);
a connector (610b) electrically connected to the power IC (660), and electrically connectable to a second electronic device (700); and
at least one processor,
wherein the at least one processor is configured to,
obtain, from the second electronic device (700), a voltage of a second battery (720) of the second electronic device (700) and a minimum voltage required for operating a second charger (710) of the second electronic device (700);
identify a first voltage based on a voltage of the first battery (650) of the first electronic device (600), the voltage of the second battery (720) of the second electronic device (700), and the minimum voltage required for operating the second charger (710) of the second electronic device (700), and
control the power IC (660) to transfer a first power having the first voltage to the second electronic device (700) via the connector (610b).

2. The first electronic device (600) of claim 1, further comprising
a first connector (610a) for a connection with an external power source,
wherein the at least one processor is further configured to:
identify whether power is supplied via the first connector (610a) from the external power source, and
identify the first voltage based on whether the power is supplied via the first connector (610a) from the external power source.

3. The first electronic device (600) of claim 1, wherein the at least one processor is further configured to:
identify whether a state of charge of the first electronic device (600) is located in a constant voltage (CV) section; and
identify the first voltage based on whether the state of charge of the first electronic device (600) is located in the CV section.

4. The first electronic device (600) of claim 3, wherein the at least one processor is further configured to identify the first voltage as a prespecified first constant voltage based on identifying that the state of charge of the first electronic device (600) is in the CV section.

5. The first electronic device (600) of claim 1, wherein the at least one processor is further configured to:
identify whether the voltage of the first battery (650) of the first electronic device exceeds the minimum voltage required for operating the second charger (710) of the second electronic device (700), and
identify the first voltage based on whether the voltage of the first battery (650) of the first electronic device (600) exceeds the minimum voltage required for operating the second charger (710) of the second electronic device (700).

6. The first electronic device (600) of claim 1, wherein the at least one processor is further configured to identify the first voltage as a value higher than a higher voltage between the voltage of the first battery (650) of the first electronic device (600) and the voltage of the second battery (720) of the second electronic device (700), based on identifying that the voltage of the first battery (650) of the first electronic device (600) is less than or equal to the minimum voltage required for operating the second charger (710) of the second electronic device (700).

7. The first electronic device (600) of claim 1, wherein the at least one processor is further configured to:
identify the voltage of the second battery (720) of the second electronic device (700);
identify whether the voltage of the second battery (720) of the second electronic device (700) is less than the voltage of the first battery (650) of the first electronic device (600); and
identify the first voltage based on whether the voltage of the second battery (720) of the second electronic device (700) is less than the voltage of the first battery (650) of the first electronic device (600).

8. The first electronic device (600) of claim 7, wherein the at least one processor is further configured to identify the first voltage as a value higher than a higher voltage between the voltage of the first battery (650) of the first electronic device (600) and the voltage of the second battery (720) of the second electronic device (700), based on identifying that the voltage of the second battery (720) of the second electronic device (700) is greater than or equal to the voltage of the first battery (650) of the first electronic device (600).

9. The first electronic device (600) of claim 1, wherein the at least one processor is further configured to,
identify the voltage of the second battery (720) of the second electronic device (700),
identify whether the voltage of the first battery (650) of the first electronic device (600) exceeds a value obtained by adding a first reference voltage to the voltage of the second battery (720) of the second electronic device (700), and
identify the first voltage based on whether the voltage of the first battery (650) of the first electronic device (600) exceeds the value obtained by adding the first reference voltage to the voltage of the second battery (720) of the second electronic device (700).

10. The first electronic device (600) of claim 9, wherein the at least one processor is further configured to identify the first voltage as a value higher than a higher voltage between the voltage of the first battery (650) of the first electronic device (600) and the voltage of the second battery (720) of the second electronic device (700), based on identifying that the voltage of the first battery (650) of the first electronic device (600) is less than or equal to a value obtained by adding the first reference voltage to the voltage of the second battery (720) of the second electronic device (700).

11. The first electronic device (600) of claim 1, wherein the at least one processor is further configured to:
identify the voltage of the second battery (720) of the second electronic device (700)|,
identify whether an average value of the voltage of the first battery (650) of the first electronic device (600) and the voltage of the second battery (720) of the second electronic device (700) exceeds the minimum voltage required for operating the second charger (710) of the second electronic device (700); and
identify the first voltage based on whether the average value of the voltage of the first battery (650) of the first electronic device (600) and the voltage of the second battery (720) of the second electronic device (700) exceeds the minimum voltage required for operating the second charger (710) of the second electronic device (700).

12. The first electronic device (600) of claim 11, wherein the at least one processor is further configured to identify the first voltage as the average value of the voltage of the first battery (650) of the first electronic device (600) and the voltage of the second battery (720) of the second electronic device (700), based on identifying that the average value of the voltage of the first battery (650) of the first electronic device (600) and the voltage of the second battery (720) of the second electronic device (700) exceeds the minimum voltage required for operating the second charger (710) of the second electronic device (700).

13. The first electronic device (600) of claim 11, wherein the at least one processor is further configured to identify the first voltage as the minimum voltage required for operating the second charger (710) of the second electronic device (700), based on identifying that the average value of the voltage of the first battery (650) of the first electronic device (600) and the voltage of the second battery (720) of the second electronic device (700) is less than or equal to the minimum voltage required for operating the second charger (710) of the second electronic device (700).

14. A method performed in a first electronic device (600) configured to supply power to a second electronic device (700), the method comprising:
obtaining, from the second electronic device (700), a voltage of a second battery (720) of the second electronic device (700) and a minimum voltage required for operating a charger (710) of the second electronic device (700);
identifying a first voltage based on a voltage of a first battery (650) of the first electronic device (600), the voltage of the second battery (720) of the second electronic device (700), and the minimum voltage required for operating the charger (710) of the second electronic device (700); and
controlling a power IC (660) of the first electronic device (600) to transfer power having the first voltage to the second electronic device (700).

15. The method of claim 14, further comprising:
identifying whether the first electronic device (600) is supplied with power from an external power source, and
wherein the identifying of the first voltage comprises identifying the first voltage based on whether the power is supplied via a connector (610b) from the external power source.

## Patentansprüche

1. Erste elektronische Einrichtung (600), umfassend:
eine erste Batterie (650);
ein erstes Ladegerät (640), das elektrisch mit der ersten Batterie (650) verbunden ist;
eine integrierte Leistungsschaltung (IC) (660), die elektrisch mit dem ersten Ladegerät (640) verbunden und dazu konfiguriert ist, eine Ausgabespannung des ersten Ladegeräts (640) umzuwandeln;
einen Verbinder (610b), der elektrisch mit der Leistungs-IC (660) verbunden ist und elektrisch mit einer zweiten elektronischen Einrichtung (700) verbindbar ist; und
mindestens einen Prozessor,
wobei der mindestens eine Prozessor zu Folgendem konfiguriert ist:
Erhalten einer Spannung einer zweiten Batterie (720) der zweiten elektronischen Einrichtung (700) und einer Mindestspannung, die zum Betreiben eines zweiten Ladegeräts (710) der zweiten elektronischen Einrichtung (700) erforderlich ist, von der zweiten elektronischen Einrichtung (700);
Identifizieren einer ersten Spannung auf Grundlage einer Spannung der ersten Batterie (650) der ersten elektronischen Einrichtung (600), der Spannung der zweiten Batterie (720) der zweiten elektronischen Einrichtung (700) und der Mindestspannung, die zum Betreiben des zweiten Ladegeräts (710) der zweiten elektronischen Einrichtung (700) erforderlich ist, und
Steuern des Leistungs-IC (660) zum Übertragen einer ersten Leistung mit der ersten Spannung über den Verbinder (610b) an die zweite elektronische Einrichtung (700).

2. Erste elektronische Einrichtung (600) nach Anspruch 1, ferner umfassend:
einen ersten Verbinder (610a) für eine Verbindung mit einer externen Leistungsquelle,
wobei der mindestens eine Prozessor ferner zu Folgendem konfiguriert ist:
Identifizieren, ob Leistung von der externen Leistungsquelle über den ersten Verbinder (610a) zugeführt wird, und
Identifizieren der ersten Spannung auf Grundlage davon, ob die Leistung von der externen Leistungsquelle über die erste Verbindung (610a) zugeführt wird.

3. Erste elektronische Einrichtung (600) nach Anspruch 1, wobei der mindestens eine Prozessor ferner zu Folgenden konfiguriert ist:
Identifizieren, ob sich ein Ladezustand der ersten elektronischen Einrichtung (600) in einem Abschnitt mit konstanter Spannung (CV) befindet; und
Identifizieren der ersten Spannung auf Grundlage davon, ob sich der Ladezustand der ersten elektronischen Einrichtung (600) in dem CV-Abschnitt befindet.

4. Erste elektronische Einrichtung (600) nach Anspruch 3, wobei der mindestens eine Prozessor ferner dazu konfiguriert ist, auf Grundlage des Identifizierens, dass sich der Ladezustand der ersten elektronischen Einrichtung (600) in dem CV-Abschnitt befindet, die erste Spannung als eine vorgegebene erste konstante Spannung zu identifizieren.

5. Erste elektronische Einrichtung (600) nach Anspruch 1, wobei der mindestens eine Prozessor ferner zu Folgenden konfiguriert ist:
Identifizieren, ob die Spannung der ersten Batterie (650) der ersten elektronischen Einrichtung die Mindestspannung überschreitet, die zum Betreiben des zweiten Ladegeräts (710) der zweiten elektronischen Einrichtung (700) erforderlich ist, und Identifizieren der ersten Spannung auf Grundlage davon, ob die Spannung der ersten Batterie (650) der ersten elektronischen Einrichtung (600) die Mindestspannung überschreitet, die zum Betreiben des zweiten Ladegeräts (710) der zweiten elektronischen Einrichtung (700) erforderlich ist.

6. Erste elektronische Einrichtung (600) nach Anspruch 1, wobei der mindestens eine Prozessor ferner dazu konfiguriert ist, auf Grundlage des Identifizierens, dass die Spannung der ersten Batterie (650) der ersten elektronischen Einrichtung (600) kleiner als die Mindestspannung, die zum Betreiben des zweiten Ladegeräts (710) der zweiten elektronischen Einrichtung (700) erforderlich ist, oder gleich dieser ist, die erste Spannung als einen Wert zu identifizieren, der höher als eine höhere Spannung zwischen der Spannung der ersten Batterie (650) der ersten elektronischen Einrichtung (600) und der Spannung der zweiten Batterie (720) der zweiten elektronischen Einrichtung (700) ist.

7. Erste elektronische Einrichtung (600) nach Anspruch 1, wobei der mindestens eine Prozessor ferner zu Folgenden konfiguriert ist:
Identifizieren der Spannung der zweiten Batterie (720) der zweiten elektronischen Einrichtung (700);
Identifizieren, ob die Spannung der zweiten Batterie (720) der zweiten elektronischen Einrichtung (700) kleiner als die Spannung der ersten Batterie (650) der ersten elektronischen Einrichtung (600) ist; und
Identifizieren der ersten Spannung auf Grundlage davon, ob die Spannung der zweiten Batterie (720) der zweiten elektronischen Einrichtung (700) kleiner als die Spannung der ersten Batterie (650) der ersten elektronischen Einrichtung (600) ist.

8. Erste elektronische Einrichtung (600) nach Anspruch 7, wobei der mindestens eine Prozessor ferner dazu konfiguriert ist, auf Grundlage des Identifizierens, dass die Spannung der zweiten Batterie (720) der zweiten elektronischen Einrichtung (700) größer als die Spannung der ersten Batterie (650) der ersten elektronischen Einrichtung (600) oder gleich dieser ist, die erste Spannung als einen Wert zu identifizieren, der höher als eine höhere Spannung zwischen der Spannung der ersten Batterie (650) der ersten elektronischen Einrichtung (600) und der Spannung der zweiten Batterie (720) der zweiten elektronischen Einrichtung (700) ist.

9. Erste elektronische Einrichtung (600) nach Anspruch 1, wobei der mindestens eine Prozessor ferner zu Folgenden konfiguriert ist:
Identifizieren der Spannung der zweiten Batterie (720) der zweiten elektronischen Einrichtung (700),
Identifizieren, ob die Spannung der ersten Batterie (650) der ersten elektronischen Einrichtung (600) einen Wert überschreitet, der durch Addieren einer ersten Referenzspannung zu der Spannung der zweiten Batterie (720) der zweiten elektronischen Einrichtung (700) erhalten wird, und
Identifizieren der ersten Spannung auf Grundlage davon, ob die Spannung der ersten Batterie (650) der ersten elektronischen Einrichtung (600) den Wert überschreitet, der durch Addieren der ersten Referenzspannung zu der Spannung der zweiten Batterie (720) der zweiten elektronischen Einrichtung (700) erhalten wird.

10. Erste elektronische Einrichtung (600) nach Anspruch 9, wobei der mindestens eine Prozessor ferner dazu konfiguriert ist, auf Grundlage des Identifizierens, dass die Spannung der ersten Batterie (650) der ersten elektronischen Einrichtung (600) kleiner als ein Wert, der durch Addieren der ersten Referenzspannung zu der Spannung der zweiten Batterie (720) der zweiten elektronischen Einrichtung (700) oder gleich diesem ist, die erste Spannung als einen Wert zu identifizieren, der höher als eine höhere Spannung zwischen der Spannung der ersten Batterie (650) der ersten elektronischen Einrichtung (600) und der Spannung der zweiten Batterie (720) der zweiten elektronischen Einrichtung (700) ist.

11. Erste elektronische Einrichtung (600) nach Anspruch 1, wobei der mindestens eine Prozessor ferner zu Folgenden konfiguriert ist:
Identifizieren der Spannung der zweiten Batterie (720) der zweiten elektronischen Einrichtung (700);
Identifizieren, ob ein Durchschnittswert der Spannung der ersten Batterie (650) der ersten elektronischen Einrichtung (600) und der Spannung der zweiten Batterie (720) der zweiten elektronischen Einrichtung (700) die Mindestspannung überschreitet, die zum Betreiben des zweiten Ladegeräts (710) der zweiten elektronischen Einrichtung (700) erforderlich ist, und
Identifizieren der ersten Spannung auf Grundlage davon, ob der Durchschnittswert der Spannung der ersten Batterie (650) der ersten elektronischen Einrichtung (600) und der Spannung der zweiten Batterie (720) der zweiten elektronischen Einrichtung (700) die Mindestspannung überschreitet, die zum Betreiben des zweiten Ladegeräts (710) der zweiten elektronischen Einrichtung (700) erforderlich ist.

12. Erste elektronische Einrichtung (600) nach Anspruch 11, wobei der mindestens eine Prozessor ferner dazu konfiguriert ist, auf Grundlage des Identifizierens, dass der Durchschnittswert der Spannung der ersten Batterie (650) der ersten elektronischen Einrichtung (600) und der Spannung der zweiten Batterie (720) der zweiten elektronischen Einrichtung (700) die Mindestspannung überschreitet, die zum Betreiben des zweiten Ladegeräts (710) der zweiten elektronischen Einrichtung (700) erforderlich ist, die erste Spannung als den Durchschnittswert der Spannung der ersten Batterie (650) der ersten elektronischen Einrichtung (600) und der Spannung der zweiten Batterie (720) der zweiten elektronischen Einrichtung (700) zu identifizieren.

13. Erste elektronische Einrichtung (600) nach Anspruch 11, wobei der mindestens eine Prozessor ferner dazu konfiguriert ist, auf Grundlage des Identifizierens, dass der Durchschnittswert der Spannung der ersten Batterie (650) der ersten elektronischen Einrichtung (600) und der Spannung der zweiten Batterie (720) der zweiten elektronischen Einrichtung (700) kleiner als die Mindestspannung, die zum Betreiben des zweiten Ladegeräts (710) der zweiten elektronischen Einrichtung (700) erforderlich ist, oder gleich diesem ist, die erste Spannung als die Mindestspannung zu identifizieren, die zum Betreiben des zweiten Ladegeräts (710) der zweiten elektronischen Einrichtung (700) erforderlich ist.

14. Verfahren, das in einer ersten elektronischen Einrichtung (600) durchgeführt wird, die dazu konfiguriert ist, einer zweiten elektronischen Einrichtung (700) Leistung zuzuführen, wobei das Verfahren Folgendes umfasst:
Erhalten einer Spannung einer zweiten Batterie (720) der zweiten elektronischen Einrichtung (700) und einer Mindestspannung, die zum Betreiben eines Ladegeräts (710) der zweiten elektronischen Einrichtung (700) erforderlich ist, von der zweiten elektronischen Einrichtung (700);
Identifizieren einer ersten Spannung auf Grundlage einer Spannung einer ersten Batterie (650) der ersten elektronischen Einrichtung (600), der Spannung der zweiten Batterie (720) der zweiten elektronischen Einrichtung (700) und der Mindestspannung, die zum Betreiben des Ladegeräts (710) der zweiten elektronischen Einrichtung (700) erforderlich ist, und
Steuern einer Leistungs-IC (660) der ersten elektronischen Einrichtung (600) zum Übertragen von Leistung mit der ersten Spannung an die zweite elektronische Einrichtung (700).

15. Verfahren nach Anspruch 14, ferner umfassend:
Identifizieren, ob der ersten elektronischen Einrichtung (600) von einer externen Leistungsquelle Leistung zugeführt wird, und
wobei das Identifizieren der ersten Spannung Identifizieren der ersten Spannung auf Grundlage davon umfasst, ob die Leistung von der externen Leistungsquelle über einen Verbinder (610b) zugeführt wird.

## Revendications

1. Premier dispositif électronique (600) comprenant :
une première batterie (650) ;
un premier chargeur (640) connecté électriquement à la première batterie (650) ;
un circuit intégré (CI) de puissance (660) connecté électriquement au premier chargeur (640) et configuré pour convertir une tension de sortie du premier chargeur (640) ;
un connecteur (610b) connecté électriquement au CI de puissance (660), et pouvant être connecté électriquement à un second dispositif électronique (700) ; et
au moins un processeur,
ledit au moins un processeur étant configuré pour,
obtenir, à partir du second dispositif électronique (700), une tension d'une seconde batterie (720) du second dispositif électronique (700) et une tension minimale requise pour faire fonctionner un second chargeur (710) du second dispositif électronique (700) ;
identifier une première tension sur la base d'une tension de la première batterie (650) du premier dispositif électronique (600), de la tension de la seconde batterie (720) du second dispositif électronique (700) et de la tension minimale requise pour faire fonctionner le second chargeur (710) du second dispositif électronique (700), et
commander le CI de puissance (660) pour transférer une première puissance possédant la première tension au second dispositif électronique (700) par l'intermédiaire du connecteur (610b).

2. Premier dispositif électronique (600) de la revendication 1, comprenant en outre
un premier connecteur (610a) pour une connexion avec une source d'alimentation externe,
ledit au moins un processeur étant en outre configuré pour :
identifier si la puissance est fournie par l'intermédiaire du premier connecteur (610a) à partir de la source d'alimentation externe, et
identifier la première tension sur la base que la puissance est fournie ou non par l'intermédiaire du premier connecteur (610a) à partir de la source d'alimentation externe.

3. Premier dispositif électronique (600) de la revendication 1, ledit au moins un processeur étant en outre configuré pour :
identifier si un état de charge du premier dispositif électronique (600) est situé dans une section à tension constante (CV) ; et
identifier la première tension sur la base que l'état de charge du premier dispositif électronique (600) est situé ou non dans la section CV.

4. Premier dispositif électronique (600) de la revendication 3, ledit au moins un processeur étant en outre configuré pour identifier la première tension en tant que première tension constante prédéfinie sur la base de l'identification selon laquelle l'état de charge du premier dispositif électronique (600) se trouve dans la section CV.

5. Premier dispositif électronique (600) de la revendication 1, ledit au moins un processeur étant en outre configuré pour :
identifier si la tension de la première batterie (650) du premier dispositif électronique dépasse la tension minimale requise pour faire fonctionner le second chargeur (710) du second dispositif électronique (700), et
identifier la première tension sur la base que la tension de la première batterie (650) du premier dispositif électronique (600) dépasse ou non la tension minimale requise pour faire fonctionner le second chargeur (710) du second dispositif électronique (700).

6. Premier dispositif électronique (600) de la revendication 1, ledit au moins un processeur étant en outre configuré pour identifier la première tension en tant que valeur supérieure à une tension supérieure entre la tension de la première batterie (650) du premier dispositif électronique (600) et la tension de la seconde batterie (720) du second dispositif électronique (700), sur la base de l'identification selon laquelle la tension de la première batterie (650) du premier dispositif électronique (600) est inférieure ou égale à la tension minimale requise pour faire fonctionner le second chargeur (710) du second dispositif électronique (700).

7. Premier dispositif électronique (600) de la revendication 1, ledit au moins un processeur étant en outre configuré pour :
identifier la tension de la seconde batterie (720) du second dispositif électronique (700) ;
identifier si la tension de la seconde batterie (720) du second dispositif électronique (700) est inférieure à la tension de la première batterie (650) du premier dispositif électronique (600) ; et
identifier la première tension sur la base que la tension de la seconde batterie (720) du second dispositif électronique (700) est inférieure ou non à la tension de la première batterie (650) du premier dispositif électronique (600).

8. Premier dispositif électronique (600) de la revendication 7, ledit au moins un processeur étant en outre configuré pour identifier la première tension en tant que valeur supérieure à une tension supérieure entre la tension de la première batterie (650) du premier dispositif électronique (600) et la tension de la seconde batterie (720) du second dispositif électronique (700), sur la base de l'identification que la tension de la seconde batterie (720) du second dispositif électronique (700) est supérieure ou égale à la tension de la première batterie (650) du premier dispositif électronique (600).

9. Premier dispositif électronique (600) de la revendication 1, ledit au moins un processeur étant en outre configuré pour,
identifier la tension de la seconde batterie (720) du second dispositif électronique (700),
identifier si la tension de la première batterie (650) du premier dispositif électronique (600) dépasse une valeur obtenue en ajoutant une première tension de référence à la tension de la seconde batterie (720) du second dispositif électronique (700), et
identifier la première tension sur la base que la tension de la première batterie (650) du premier dispositif électronique (600) dépasse la valeur obtenue en ajoutant la première tension de référence à la tension de la seconde batterie (720) du second dispositif électronique (700).

10. Premier dispositif électronique (600) de la revendication 9, ledit au moins un processeur étant en outre configuré pour identifier la première tension en tant que valeur supérieure à une tension supérieure entre la tension de la première batterie (650) du premier dispositif électronique (600) et la tension de la seconde batterie (720) du second dispositif électronique (700), sur la base de l'identification selon laquelle la tension de la première batterie (650) du premier dispositif électronique (600) est inférieure ou égale à une valeur obtenue en ajoutant la première tension de référence à la tension de la seconde batterie (720) du second dispositif électronique (700).

11. Premier dispositif électronique (600) de la revendication 1, ledit au moins un processeur étant en outre configuré pour :
identifier la tension de la seconde batterie (720) du second dispositif électronique (700),
identifier si une valeur moyenne de la tension de la première batterie (650) du premier dispositif électronique (600) et de la tension de la seconde batterie (720) du second dispositif électronique (700) dépasse la tension minimale requise pour faire fonctionner le second chargeur (710) du second dispositif électronique (700) ; et
identifier la première tension sur la base que la valeur moyenne de la tension de la première batterie (650) du premier dispositif électronique (600) et de la tension de la seconde batterie (720) du second dispositif électronique (700) dépasse ou non la tension minimale requise pour faire fonctionner le second chargeur (710) du second dispositif électronique (700).

12. Premier dispositif électronique (600) de la revendication 11, ledit au moins un processeur étant en outre configuré pour identifier la première tension en tant que valeur moyenne de la tension de la première batterie (650) du premier dispositif électronique (600) et de la tension de la seconde batterie (720) du second dispositif électronique (700), sur la base de l'identification selon laquelle la valeur moyenne de la tension de la première batterie (650) du premier dispositif électronique (600) et de la tension de la seconde batterie (720) du second dispositif électronique (700) dépasse la tension minimale requise pour faire fonctionner le second chargeur (710) du second dispositif électronique (700).

13. Premier dispositif électronique (600) de la revendication 11, ledit au moins un processeur étant en outre configuré pour identifier la première tension en tant que tension minimale requise pour faire fonctionner le second chargeur (710) du second dispositif électronique (700), sur la base de l'identification selon laquelle la valeur moyenne de la tension de la première batterie (650) du premier dispositif électronique (600) et de la tension de la seconde batterie (720) du second dispositif électronique (700) est inférieure ou égale à la tension minimale requise pour faire fonctionner le second chargeur (710) du second dispositif électronique (700).

14. Procédé réalisé dans un premier dispositif électronique (600) configuré pour fournir une puissance à un second dispositif électronique (700), le procédé comprenant :
l'obtention, à partir du second dispositif électronique (700), d'une tension d'une seconde batterie (720) du second dispositif électronique (700) et d'une tension minimale requise pour faire fonctionner un second chargeur (710) du second dispositif électronique (700) ;
l'identification d'une première tension sur la base d'une tension d'une première batterie (650) du premier dispositif électronique (600), de la tension de la seconde batterie (720) du second dispositif électronique (700) et de la tension minimale requise pour faire fonctionner le chargeur (710) du second dispositif électronique (700) ; et
la commande d'un CI de puissance (660) du premier dispositif électronique (600) pour transférer la puissance possédant la première tension au second dispositif électronique (700).

15. Procédé de la revendication 14, comprenant en outre :
l'identification pour savoir si le premier dispositif électronique (600) est alimenté par une source d'alimentation externe, et
ladite identification de la première tension comprenant l'identification de la première tension sur la base que la puissance est fournie ou non par l'intermédiaire d'un connecteur (610b) à partir de la source d'alimentation externe.
